# EUROPEAN PATENT APPLICATION

(11) **EP 4 788 104 A1**
(43) Date of publication of application: **05.08.2026**
(21) Application number: 24873022.8
(22) Date of filing: 27.09.2024
(51) Int. Cl.: H10K 59/131, H10K 59/121, G09G 3/20

(54) **DISPLAY DEVICE**

(30) Priority: 27.09.2023 KR 20230131177; 29.11.2023 KR 20230170038
(71) Applicant: Samsung Display Co., Ltd., Yongin-si, Gyeonggi-do 17113 (KR)
(72) Inventor: CHOI, Jun Won, Yongin-si, Gyeonggi-do 17113 (KR)
(74) Representative: Marks & Clerk LLP
(86) International application number: PCT/KR2024/014681
(87) International publication number: WO 2025/071314

(57) **Abstract**

An embodiment of the present invention discloses a display apparatus including a first gate line extending in a first direction, a data line extending in a second direction intersecting the first direction, a first transistor including a first semiconductor layer and a first gate electrode overlapping the first semiconductor layer, a second transistor electrically connected to the first transistor and including a second semiconductor layer electrically connected to the data line and a second gate electrode overlapping a second semiconductor layer, a third transistor electrically connected to the first transistor and the second transistor and including a third semiconductor layer overlapping the second gate line, and a bridge electrode electrically connecting the first gate line to the second gate electrode.

## Description

### Technical Field

One or more embodiments relate to display apparatuses.

### Background Art

As display apparatuses visually displaying various types of electrical signal information have rapidly developed, various display apparatuses with excellent characteristics such as being slim, lightweight and power efficient have been introduced.

Examples of the display apparatuses may include a liquid crystal display apparatus using light from a backlight instead of emitting light by itself and a light-emitting display apparatus including a display element capable of emitting light. A light-emitting display apparatus may include display elements including an emission layer

### Disclosure of Invention

### Technical Problem

One or more embodiments provide a display apparatus, and more particularly, a light-emitting display apparatus.

### Solution to Problem

Additional aspects will be set forth in part in the description which follows and, in part, will be apparent from the description, or may be learned by practice of the presented embodiments of the disclosure.

According to one or more embodiments, a display apparatus may include a first gate line and a second gate line extending in a first direction, a data line extending in a second direction intersecting the first direction, a first transistor including a first semiconductor layer and a first gate electrode overlapping the first semiconductor layer, a second transistor electrically connected to the first transistor and including a second semiconductor layer electrically connected to the data line and a second gate electrode overlapping the second semiconductor layer, a third transistor electrically connected to the first transistor and the second transistor and including a third semiconductor layer overlapping the second gate line, and a bridge electrode electrically connecting the first gate line to the second gate electrode.

The display apparatus may further include a first connection electrode electrically connecting the first gate electrode, the second semiconductor layer, and the third semiconductor layer to each other, wherein the first connection electrode may not overlap the first gate line.

The second gate line may be disposed between the first connection electrode and the first gate line.

The display apparatus may further include a first capacitor electrically connected to the first gate electrode, wherein the first connection electrode may be electrically connected to a first electrode of the first capacitor.

The first electrode of the first capacitor and the first gate electrode may be integral with each other.

The first electrode of the first capacitor and the first gate electrode may be arranged on different layers.

The second semiconductor layer and the third semiconductor layer may be integral with each other.

The first gate line may include a 1st-1 gate line, and a 1st-2 gate line overlapping the 1st-1 gate line, wherein at least one insulating layer may be disposed between the 1st-1 gate line and the 1st-2 gate line, and the 1st-2 gate line may be electrically connected to the 1st-1 gate line through a contact hole passing through the at least one insulating layer.

The second gate line may be arranged between the first gate line and the second semiconductor layer, and the second gate line may overlap the third semiconductor layer.

The display apparatus may further include a reference voltage line electrically connected to the third semiconductor layer, wherein the reference voltage line may extend in the first direction.

The reference voltage line may be arranged between the first gate line and the second gate line.

The bridge electrode and the first gate line may be integral with each other.

The bridge electrode may include the second gate electrode.

According to one or more embodiments, a display apparatus may include a first gate line extending in a first direction, a data line extending in a second direction intersecting the first direction, a first semiconductor layer including a first channel area, a conductive layer including a first gate electrode overlapping the first channel area, a semiconductor pattern spaced apart from the first gate line and the first semiconductor layer and including a second channel area and a third channel area, a second gate electrode overlapping the second channel area, a bridge electrode electrically connecting the first gate line to the second gate electrode, and a first connection electrode electrically connecting the first gate electrode to the semiconductor pattern.

The first connection electrode may be electrically connected to a middle portion of the semiconductor pattern disposed between the second channel area and the third channel area.

The semiconductor pattern may include a bent portion in a plan view, and the first connection electrode may be electrically connected to the bent portion of the semiconductor pattern.

The display apparatus may further include a second gate line extending in the first direction, wherein the second gate line may overlap the third channel area.

The display apparatus may further include a reference voltage line, wherein the data line may be electrically connected to a first portion of the semiconductor pattern, the reference voltage line may be electrically connected to a second portion of the semiconductor pattern, the first portion and the second portion of the semiconductor pattern may be disposed at opposite sides of the semiconductor pattern, and the second channel area and the third channel area may be disposed between the first portion and the second portion of the semiconductor layer.

The reference voltage line may extend in the first direction and may be disposed between the first gate line and the second gate line.

The first gate line may include a 1st-1 gate line, and a 1st-2 gate line overlapping the 1st-1 gate line, wherein at least one insulating layer may be disposed between the 1st-1 gate line and the 1st-2 gate line, and the 1st-2 gate line may be electrically connected to the 1st-1 gate line through a contact hole passing through the at least one insulating layer.

The display apparatus may further include a first capacitor including a plurality of electrodes.

The conductive layer may include one of the plurality of electrodes of the first capacitor.

Each of the plurality of electrodes of the first capacitor may be disposed on a different layer than the conductive layer, and the first connection electrode may be electrically connected to one of the plurality of electrodes of the first capacitor.

The bridge electrode and the first gate line may be integral with each other.

The bridge electrode may include the second gate electrode.

### Advantageous Effects of Invention

According to an embodiment, high-quality images may be provided. However, these effects may be merely examples and the scope of the disclosure may not be limited thereto.

### Brief Description of Drawings

The above and other aspects, features, and advantages of certain embodiments of the disclosure will be more apparent from the following description taken in conjunction with the accompanying drawings.
FIG. 1 is a plan view schematically illustrating a display apparatus according to an embodiment.
FIG. 2 is a block diagram schematically illustrating a display apparatus according to an embodiment.
FIG. 3A is a schematic diagram of an equivalent circuit illustrating a light-emitting diode which may be a light-emitting element corresponding to a pixel of a display apparatus according to an embodiment, and a pixel circuit electrically connected to the light-emitting diode.
FIG. 3B is a schematic diagram of an equivalent circuit illustrating a light-emitting diode which may be a light-emitting element corresponding to a pixel of a display apparatus according to an embodiment, and a pixel circuit electrically connected to the light-emitting diode.
FIG. 4 is a schematic cross-sectional view illustrating a portion of a display apparatus according to an embodiment.
FIGS. 5 to 10 are plan views illustrating a process of forming a pixel circuit included in a display apparatus according to an embodiment.
FIG. 11 is a plan view illustrating a portion of a pixel circuit according to an embodiment.
FIG. 12 is a cross-sectional view schematically illustrating a display apparatus according to an embodiment.
FIGS. 13 to 19 are plan views illustrating a process of forming a pixel circuit included in a display apparatus according to an embodiment.
FIG. 20 is a plan view illustrating a portion of a pixel circuit according to an embodiment.
FIGS. 21 and 22 are each a plan view illustrating a portion of a pixel circuit of a display apparatus according to an embodiment.

### Best Mode for Carrying out the Invention

According to one or more embodiments, a display apparatus may include a first gate line and a second gate line extending in a first direction, a data line extending in a second direction intersecting the first direction, a first transistor including a first semiconductor layer and a first gate electrode overlapping the first semiconductor layer, a second transistor electrically connected to the first transistor and including a second semiconductor layer electrically connected to the data line and a second gate electrode overlapping the second semiconductor layer, a third transistor electrically connected to the first transistor and the second transistor and including a third semiconductor layer overlapping the second gate line, and a bridge electrode electrically connecting the first gate line to the second gate electrode.

According to one or more embodiments, a display apparatus may include a first gate line extending in a first direction, a data line extending in a second direction intersecting the first direction, a first semiconductor layer including a first channel area, a conductive layer including a first gate electrode overlapping the first channel area, a semiconductor pattern spaced apart from the first gate line and the first semiconductor layer and including a second channel area and a third channel area, a second gate electrode overlapping the second channel area, a bridge electrode electrically connecting the first gate line to the second gate electrode, and a first connection electrode electrically connecting the first gate electrode to the semiconductor pattern.

### Mode for the Invention

The disclosure may include various embodiments and modifications, and particular embodiments thereof are illustrated in the drawings and will be described herein in detail. The effects and features of the disclosure and the accomplishing methods thereof will become apparent from the embodiments described below in detail with reference to the accompanying drawings. However, the disclosure is not limited to the embodiments described below, and may be embodied in various modes.

Hereinafter, embodiments will be described in detail with reference to the accompanying drawings, and in the following description, like reference numerals will denote like elements and redundant descriptions thereof will be omitted.

It will be understood that although terms such as "first" and "second" may be used herein to describe various elements, these elements should not be limited by these terms and these terms are only used to distinguish one element from another element.

As used herein, the singular forms "a," "an," and "the" are intended to include the plural forms as well, unless the context clearly indicates otherwise.

Also, it will be understood that the terms "comprise," "include," and "have" used herein specify the presence of stated features or elements, but do not preclude the presence or addition of one or more other features or elements.

It will be understood that when a layer, region, area, component, or element is referred to as being "on" another layer, region, area, component, or element, it may be "directly on" the other layer, region, area, component, or element or may be "indirectly on" the other layer, region, area, component, or element with one or more intervening layers, regions, areas, components, or elements therebetween.

Sizes of elements in the drawings may be exaggerated for convenience of description. In other words, because the sizes and shapes of components in the drawings are arbitrarily illustrated for convenience of description, the disclosure is not limited thereto.

When a certain embodiment may be implemented differently, a particular process order may be performed differently from the described order. For example, two processes described in succession may be performed substantially at the same time or may be performed in an order opposite to the described order.

As used herein, "A and/or B" represents the case of A, B, or A and B. Also, "at least one of A and B" or "at least one of A or B" represents the case of A, B, or A and B.

It will be understood that when a layer, region, or component is referred to as being "connected to" another layer, region, or component, it may be "directly connected to" the other layer, region, or component or may be "indirectly connected to" the other layer, region, or component with one or more intervening layers, regions, or components therebetween. For example, it will be understood that when a layer, region, or component is referred to as being "electrically connected to" another layer, region, or component, it may be "directly electrically connected to" the other layer, region, or component and/or may be "indirectly electrically connected to" the other layer, region, or component with one or more intervening layers, regions, or components therebetween.

The x-axis, the y-axis, and the z-axis are not limited to three axes of the rectangular coordinate system and may be interpreted in a broader sense. For example, the x-axis, y-axis, and z-axis may be perpendicular to each other or may refer to different directions that are not perpendicular to each other.

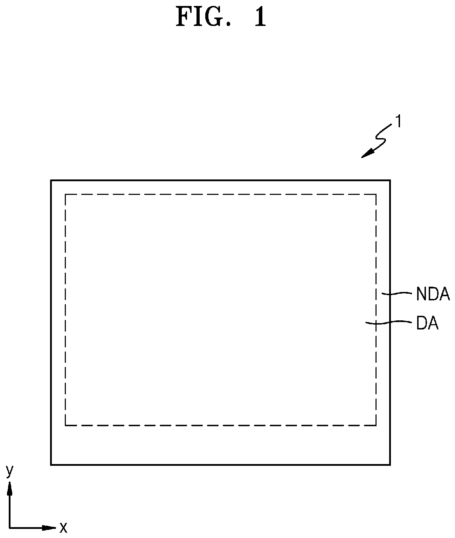

FIG. 1 is a plan view schematically illustrating a display apparatus according to an embodiment.

Referring to FIG. 1, a display apparatus 1 may include a display area DA displaying an image and a non-display area NDA outside the display area DA. The display area DA may be entirely surrounded by the non-display area NDA.

In a plan view, the display area DA may have a rectangular shape. In other embodiments, the display area DA may have a polygonal shape such as a triangular, pentagonal, or hexagonal shape, a circular shape, an elliptical shape, an atypical shape, or the like. A corner of the edge of the display area DA may be rounded.

The display apparatus 1 of FIG. 1 may be an apparatus displaying a moving image or a still image and may be used in portable electronic apparatuses such as mobile phones, laptop computers, tablet personal computers (PCs), smart phones, mobile communication terminals, electronic notebooks, electronic books, portable multimedia players (PMPs), navigation apparatuses, or ultra mobile PCs (UMPCs). The display apparatus 1 may be used in televisions, monitors, billboards, and electronic apparatuses for Internet of Things (IoT) or may be used in wearable electronic apparatuses such as smart watches, watch phones, glasses-type displays, and head-mounted displays (HMDs). Also, the display apparatus 1 according to an embodiment may be applied to a center information display (CID) arranged at a vehicle's instrument panel or a vehicle's center fascia or dashboard, a room mirror display replacing a vehicle's side mirror, or a display electronic apparatus arranged at a rear side of a vehicle's front seat as entertainment for a vehicle's rear seat.

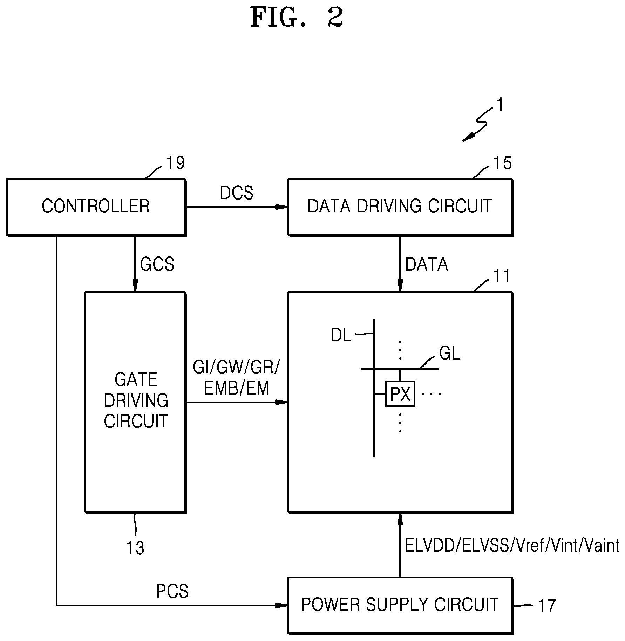

FIG. 2 is a block diagram schematically illustrating a display apparatus according to an embodiment.

Referring to FIGS. 1 and 2, the display apparatus 1 according to an embodiment may include a pixel portion 11, a gate driving circuit 13, a data driving circuit 15, a power supply circuit 17, and a controller 19.

The pixel portion 11 may include multiple pixels PX arranged in the display area DA (see FIG. 1). The pixels PX may be arranged in various forms such as stripe arrangement, PenTile^{®} arrangement (diamond arrangement), and mosaic arrangement to implement an image. Each pixel PX may include a display element (e.g., a light-emitting diode), and the display element may be electrically connected to a pixel circuit. The pixels PX may represent an image by using light emitted from a display element corresponding to each pixel PX. Each pixel circuit may be electrically connected to a gate line GL and a data line DL and may include multiple transistors and at least one capacitor.

Various conductive lines for transmitting electrical signals to be applied to the display area DA (see FIG. 1), peripheral circuits electrically connected to pixel circuits, and/or pads to which a printed circuit board or a driver IC chip may be attached may be located in the non-display area NDA (see FIG. 1). For example, the gate driving circuit 13, the data driving circuit 15, the power supply circuit 17, and the controller 19 may be provided in the non-display area NDA (see FIG. 1).

The gate driving circuit 13 may be electrically connected to multiple gate lines GL, may generate a gate signal in response to a control signal GCS from the controller 19, and may sequentially supply the gate signal to the gate lines GL. The gate signal may be a gate control signal for controlling turn-on and turn-off of the transistor electrically connected to the gate line GL. The gate signal may be a square wave signal including an on voltage at which the transistor may be turned on and an off voltage at which the transistor may be turned off. In an embodiment, the on voltage may be a high-level voltage (first-level voltage) or a low-level voltage (second-level voltage).

FIG. 2 illustrates that a pixel circuit corresponding to a pixel PX may be electrically connected to a gate line GL; however, this may be merely an example and a pixel circuit corresponding to a pixel PX may be electrically connected to two or more gate lines and the gate driving circuit 13 may supply, to the corresponding gate lines, two or more gate signals with different timings in the case that an on voltage is applied. For example, the pixel circuit may be electrically connected to first to fifth gate lines, and the gate driving circuit 13 may apply a first gate signal GW, a second gate signal GR, a third gate signal EM, a fourth gate signal GI, and a fifth gate signal EMB to the first gate line, the second gate line, the third gate line, the fourth gate line, and the fifth gate line, respectively. The third gate signal EM may be an emission control signal for controlling turn-on and turn-off of the transistor whose gate may be electrically connected to the third gate line.

The data driving circuit 15 may be electrically connected to multiple data lines DL and may supply a data signal to the data lines DL in response to a control signal DCS from the controller 19. The data signal supplied to the data line DL may be supplied to the pixel circuit. The data driving circuit 15 may convert input image data with gradation input from the controller 19 into a data signal in the form of a voltage or current.

The power supply circuit 17 may generate voltages desirable for driving the pixel PX, in response to a control signal PCS from the controller 19. The power supply circuit 17 may generate a driving voltage ELVDD and a common voltage ELVSS and supply the same to the pixels PX. The driving voltage ELVDD may be a high-level voltage provided to a first electrode (pixel electrode or anode) of the display element included in the pixel PX. The common voltage ELVSS may be a low-level voltage provided to a second electrode (opposite electrode or cathode) of the display element included in the pixel PX. The power supply circuit 17 may generate a reference voltage Vref, a first initialization voltage Vaint, and a second initialization voltage Vint and supply the same to the pixels PX.

The voltage level of the driving voltage ELVDD may be higher than the voltage level of the common voltage ELVSS. The voltage level of the reference voltage Vref may be lower than the voltage level of the driving voltage ELVDD. The voltage level of the first initialization voltage Vaint may be higher than the voltage level of the second initialization voltage Vint. The voltage level of the second initialization voltage Vint may be lower than the voltage level of the common voltage ELVSS. The voltage level of the first initialization voltage Vaint may be equal to or higher than the voltage level of the common voltage ELVSS.

The controller 19 may generate control signals GCS, DCS, and PCS based on signals input from outside and supply the same to the gate driving circuit 13, the data driving circuit 15, and the power supply circuit 17. The control signal GCS output to the gate driving circuit 13 may include multiple clock signals and a gate start signal. The control signal DCS output to the data driving circuit 15 may include a source start signal and clock signals.

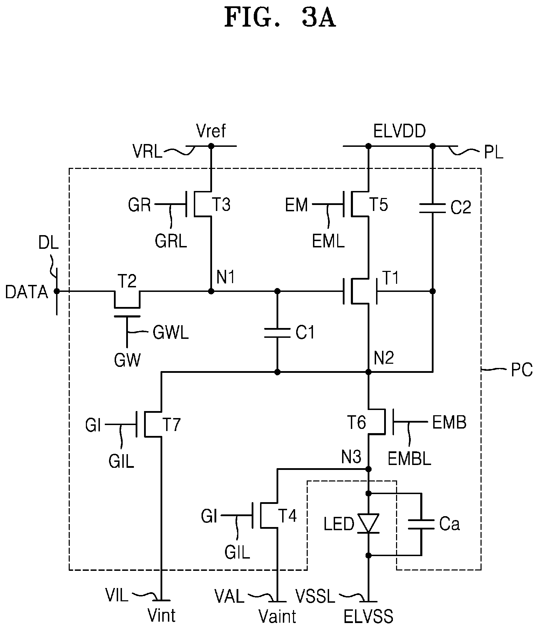

FIG. 3A is a schematic diagram of an equivalent circuit illustrating a light-emitting diode which may be a light-emitting element corresponding to a pixel of a display apparatus according to an embodiment, and a pixel circuit electrically connected to the light-emitting diode.

A pixel circuit PC may be electrically connected to a first gate line GWL configured to transmit a first gate signal GW, a second gate line GRL configured to transmit a second gate signal GR, a third gate line EML configured to transmit a third gate signal EM, a fourth gate line GIL configured to transmit a fourth gate signal GI, a fifth gate line EMBL configured to transmit a fifth gate signal EMB, and a data line DL configured to transmit a data signal DATA. Because the light emission of a light-emitting diode LED may be controlled by the third gate signal EM and the fifth gate signal EMB, the third gate signal EM and the fifth gate signal EMB may be referred to as an emission control signal and the third gate line EML and the fifth gate line EMBL may be referred to as an emission control line. The pixel circuit PC may be electrically connected to a driving voltage line PL configured to transmit a driving voltage ELVDD, a reference voltage line VRL configured to transmit a reference voltage Vref, a first initialization voltage line VAL configured to transmit a first initialization voltage Vaint, and a second initialization voltage line VIL configured to transmit a second initialization voltage Vint.

In an embodiment, multiple transistors included in the pixel circuit PC may be N-type oxide transistors. The oxide transistor may be a transistor whose semiconductor layer includes an oxide. However, this may be merely an example, and the transistors of the disclosure may not be limited thereto. For example, the semiconductor layer included in the N-type transistor may include an inorganic semiconductor (e.g., amorphous silicon or polysilicon) or an organic semiconductor.

The pixel circuit PC may include first to seventh transistors T1, T2, T3, T4, T5, T6, and T7, first and second capacitors C1 and C2, and an auxiliary capacitor Ca. The first transistor T1 may be a driving transistor outputting a driving current corresponding to the data signal DATA, and the second to seventh transistors T2, T3, T4, T5, T6, and T7 may be switching transistors configured to transmit signals. A first terminal (or a first electrode) and a second terminal (or a second electrode) of each of the first to seventh transistors T1, T2, T3, T4, T5, T6, and T7 may be a source (or a source electrode) or a drain (or a drain electrode) depending on the voltages of the first terminal and the second terminal. For example, depending on the voltages of the first terminal and the second terminal, the first terminal may be a drain and the second terminal may be a source, or the first terminal may be a source and the second terminal may be a drain. Hereinafter, a node to which a 1st-1 gate electrode of the first transistor T1 may be electrically connected may be defined as a first node N1, and a node to which a second terminal of the first transistor T1 may be electrically connected may be defined as a second node N2.

The first transistor T1 may be electrically connected to the driving voltage line PL and the light-emitting diode LED. The first transistor T1 may be electrically connected between the fifth transistor T5 and the sixth transistor T6. The first transistor T1 may include a first gate (or a first gate electrode), a first terminal, and a second terminal electrically connected to the second node N2. The first transistor T1 may include a 1st-1 gate electrically connected to the first node N1. The first transistor T1 may further include a 1st-2 gate electrically connected to the second terminal thereof. The 1st-1 gate and the 1st-2 gate may be arranged on different layers to face each other. For example, the 1st-1 gate and the 1st-2 gate of the first transistor T1 may face each other with a semiconductor layer therebetween. Herein, the first gate (or the first gate electrode) of the first transistor T1 may refer to the 1st-1 gate (or the 1st-1 gate electrode) involved in turning on and off the first transistor T1.

The gate (or the 1st-1 gate) of the first transistor T1 may be electrically connected to the second terminal of the second transistor T2, the first terminal of the third transistor T3, and the first capacitor C1. The 1st-2 gate of the first transistor T1 may be electrically connected to the first terminal of the sixth transistor T6, the first capacitor C1, and the second capacitor C2. The first terminal of the first transistor T1 may be electrically connected to the driving voltage line PL via the fifth transistor T5, and the second terminal thereof may be electrically connected to the pixel electrode of the light-emitting diode LED via the sixth transistor T6. The first terminal of the first transistor T1 may be electrically connected to the second terminal of the fifth transistor T5. The second terminal of the first transistor T1 may be electrically connected to the first terminal of the sixth transistor T6, the first capacitor C1, and the second capacitor C2. The first transistor T1 may receive a data signal DATA according to a switching operation of the second transistor T2 to control the amount of a driving current flowing through the light-emitting diode LED.

The second transistor T2 may be electrically connected to the data line DL and the gate of the first transistor T1. The second transistor T2 may include a gate electrically connected to the first gate line GWL, a first terminal electrically connected to the data line DL, and a second terminal electrically connected to the first node N1. The second terminal of the second transistor T2 may be electrically connected to the gate of the first transistor T1, the first terminal of the third transistor T3, and the first capacitor C1. The second transistor T2 may be turned on by the first gate signal GW received through the first gate line GWL, to electrically connect the data line DL with the first node N1 and transmit the data signal DATA received through the data line DL, to the first node N1.

The third transistor T3 may be electrically connected to the gate of the first transistor T1 and the reference voltage line VRL. The third transistor T3 may include a gate electrically connected to the second gate line GRL, a first terminal electrically connected to the first node N1, and a second terminal electrically connected to the reference voltage line VRL. The first terminal of the third transistor T3 may be electrically connected to the gate of the first transistor T1, the second terminal of the second transistor T2, and the first capacitor C1. The third transistor T3 may be turned on by the second gate signal GR received through the second gate line GRL, to transmit the reference voltage Vref received through the reference voltage line VRL, to the first node N1.

The fourth transistor T4 may be electrically connected to the sixth transistor T6 and the first initialization voltage line VAL. The fourth transistor T4 may be electrically connected to the light-emitting diode LED and the first initialization voltage line VAL. The fourth transistor T4 may include a gate electrically connected to the fourth gate line GIL, a first terminal electrically connected to a third node N3, and a second terminal electrically connected to the first initialization voltage line VAL. The first terminal of the fourth transistor T4 may be electrically connected to the second terminal of the sixth transistor T6 and the pixel electrode of the light-emitting diode LED. The fourth transistor T4 may be turned on by the fourth gate signal GI received through the fourth gate line GIL, to transmit the first initialization voltage Vaint received through the first initialization voltage line VAL, to the third node N3 and initialize the pixel electrode (e.g., the anode) of the light-emitting diode LED.

The fifth transistor T5 may be electrically connected to the driving voltage line PL and the first transistor T1. The fifth transistor T5 may include a gate electrically connected to the third gate line EML, a first terminal electrically connected to the driving voltage line PL, and a second terminal electrically connected to the first terminal of the first transistor T1. The fifth transistor T5 may be turned on or off according to the third gate signal EM received through the third gate line EML.

The sixth transistor T6 may be electrically connected to the first transistor T1 and the light-emitting diode LED. The sixth transistor T6 may be electrically connected between the second node N2 and the third node N3. The sixth transistor T6 may include a gate electrically connected to the fifth gate line EMBL, a first terminal electrically connected to the second node N2, and a second terminal electrically connected to the third node N3. The first terminal of the sixth transistor T6 may be electrically connected to the second terminal of the first transistor T1, the first capacitor C1, and the second capacitor C2. The second terminal of the sixth transistor T6 may be electrically connected to the first terminal of the fourth transistor T4 and the pixel electrode of the light-emitting diode LED. The sixth transistor T6 may be turned on or off according to the fifth gate signal EMB received through the fifth gate line EMBL.

The seventh transistor T7 may be electrically connected between the first transistor T1 and the second initialization voltage line VIL. The seventh transistor T7 may include a gate electrically connected to the fourth gate line GIL, a first terminal electrically connected to the second node N2, and a second terminal electrically connected to the second initialization voltage line VIL. The first terminal of the seventh transistor T7 may be electrically connected to the second terminal of the first transistor T1, the first terminal of the sixth transistor T6, the first capacitor C1, and the second capacitor C2. The seventh transistor T7 may be turned on by the fourth gate signal GI received through the fourth gate line GIL, to transmit the second initialization voltage Vint received through the second initialization voltage line VIL, to the second node N2.

The first capacitor C1 may be electrically connected between the gate of the first transistor T1 and the second terminal of the first transistor T1. The first electrode of the first capacitor C1 may be electrically connected to the first node N1, and the second electrode thereof may be electrically connected to the second node N2. The first electrode of the first capacitor C1 may be electrically connected to the gate of the first transistor T1, the second terminal of the second transistor T2, and the first terminal of the third transistor T3. The second electrode of the first capacitor C1 may be electrically connected to the second terminal and the 1st-2 gate of the first transistor T1, the second electrode of the second capacitor C2, and the first terminal of the sixth transistor T6. The first capacitor C1 may be a storage capacitor and may store a threshold voltage of the first transistor T1 and a voltage corresponding to the data signal DATA.

The first transistor T1 may be turned on in the case that the third transistor T3 and the fifth transistor T5 are turned on. In the case that the voltage of the second terminal of the first transistor T1 drops to the difference (Vref-Vth1) between the reference voltage Vref and the threshold voltage (Vth1) of the first transistor T1, the first transistor T1 may be turned off and a voltage corresponding to the threshold voltage (Vth1) of the first transistor T1 may be stored in the first capacitor C1 and thus the threshold voltage (Vth1) of the first transistor T1 may be compensated.

The second capacitor C2 may be electrically connected between the driving voltage line PL and the second node N2. The first electrode of the second capacitor C2 may be electrically connected to the driving voltage line PL. The second electrode of the second capacitor C2 may be electrically connected to the second terminal and the 1st-2 gate of the first transistor T1, the second electrode of the first capacitor C1, and the first terminal of the sixth transistor T6.

The capacitance of each of the first capacitor C1 and the second capacitor C2 may vary depending on the color of light emitted from the light-emitting diode LED.

The auxiliary capacitor Ca may be electrically connected to the sixth transistor T6, a sustain voltage line VSSL, and the pixel electrode of the light-emitting diode LED. The auxiliary capacitor Ca may store and maintain a voltage corresponding to the voltage difference between the pixel electrode of the light-emitting diode LED and the sustain voltage line VSSL, thereby preventing the problem of the black luminance increasing in case that the sixth transistor T6 is turned off.

The light-emitting diode LED may be electrically connected to the first transistor T1 through the sixth transistor T6. The light-emitting diode LED may include a pixel electrode (anode) electrically connected to the third node N3 and an opposite electrode (cathode) facing the pixel electrode, and the opposite electrode may receive a common voltage ELVSS. In an embodiment, the opposite electrode (cathode) may extend into the display area and thus may be electrically connected to the sustain voltage line VSSL configured to provide the common voltage ELVSS. The driving current output by the first transistor T1 may flow through the light-emitting diode LED due to the turned-on fifth transistor T5 and the turned-on sixth transistor T6, and the light-emitting diode LED may emit light with a brightness corresponding to the driving current.

FIG. 3A illustrates that the pixel circuit PC includes seven transistors; however, the disclosure may not be limited thereto. In an embodiment, the pixel circuit PC may include six transistors. In other embodiments, the number of transistors in the pixel circuit PC may be 5 or less or 8 or more.

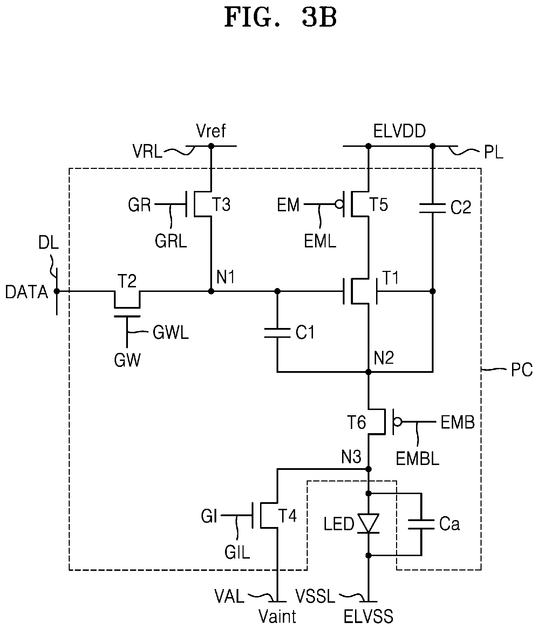

FIG. 3B is a schematic diagram of an equivalent circuit of a light-emitting diode, which may be a light-emitting element corresponding to a pixel of a display apparatus according to an embodiment, and a pixel circuit electrically connected to the light-emitting diode.

A pixel circuit PC illustrated in FIG. 3B may include first to sixth transistors T1, T2, T3, T4, T5, and T6, a first capacitor C1, a second capacitor C2, and an auxiliary capacitor Ca.

Referring to FIG. 3B, some of the transistors included in the pixel circuit PC may be N-type transistors and the others may be P-type transistors. The first to fourth transistors T1, T2, T3, and T4 may be N-type transistors, and the fifth and sixth transistors T5 and T6 may be P-type transistors. The semiconductor layers of the first to fourth transistors T1, T2, T3, and T4 may include a different material than the semiconductor layers of the fifth and sixth transistors T5 and T6. In some embodiments, the first to fourth transistors T1, T2, T3, and T4 may include a semiconductor layer including an oxide, and the fifth and sixth transistors T5 and T6 may include amorphous silicon, polysilicon, or an organic semiconductor.

The pixel circuit PC illustrated in FIG. 3B may be substantially the same as that described above with reference to FIG. 3A, except for the seventh transistor T7. The electrical connection relationship between the first to sixth transistors T1, T2, T3, T4, T5, and T6, the first capacitor C1 and the second capacitor C2, and the auxiliary capacitor Ca illustrated in FIG. 3B may be the same as that described above with reference to FIG. 3A.

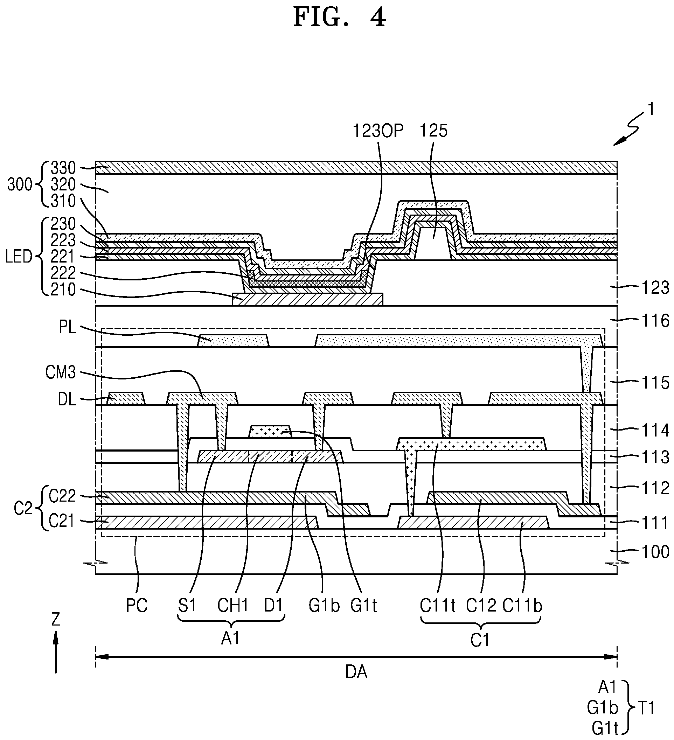

FIG. 4 is a schematic cross-sectional view illustrating a portion of a display apparatus according to an embodiment.

Referring to FIG. 4, a display apparatus 1 may include a light-emitting diode LED arranged in a display area DA. The light-emitting diode LED may be disposed over a substrate 100, and a pixel circuit PC may be arranged between the substrate 100 and the light-emitting diode LED. As an embodiment, FIG. 4 illustrates a first transistor T1, a first capacitor C1, and a second capacitor C2 as some components of the pixel circuit PC.

The substrate 100 may include a glass material or a polymer resin. In an embodiment, the substrate 100 may have an alternating stack structure of a base layer including a polymer resin and a barrier layer including an inorganic insulating material such as silicon oxide or silicon nitride. The polymer resin may include a polymer resin such as polyether sulfone, polyarylate, polyether imide, polyethylene naphthalate, polyethylene terephthalate, polyphenylene sulfide, polyimide, polycarbonate, cellulose triacetate, cellulose acetate propionate, or a combination thereof.

A first lower electrode C11b of the first capacitor C1 and a first electrode C21 of the second capacitor C2 may be disposed over the substrate 100. The first lower electrode C11b of the first capacitor C1 and the first electrode C21 of the second capacitor C2 may include a conductive material such as a metal, such as molybdenum (Mo), aluminium (Al), copper (Cu), titanium (Ti), or a combination thereof, and may include a single-layer or multiple-layer structure including the conductive material.

A first insulating layer 111 may be disposed over the first lower electrode C11b of the first capacitor C1 and the first electrode C21 of the second capacitor C2. The first insulating layer 111 may include an inorganic insulating material such as silicon oxide, silicon nitride, silicon oxynitride, or a combination thereof and may include a single-layer or multiple-layer structure including the inorganic insulating material.

Second electrodes C12 and C22 of the first capacitor C1 and the second capacitor C2 respectively may be disposed over the first insulating layer 111. The second electrodes C12 and C22 of the first capacitor C1 and the second capacitor C2 respectively may include a conductive material such as a metal, such as molybdenum (Mo), aluminium (Al), copper (Cu), titanium (Ti), or a combination thereof, and may include a single-layer or multiple-layer structure including the conductive material.

A second insulating layer 112 may be disposed over the second electrodes C12 and C22 of the first capacitor C1 and the second capacitor C2 respectively. The second insulating layer 112 may include an inorganic insulating material such as silicon oxide, silicon nitride, silicon oxynitride, or a combination thereof and may include a single-layer or multiple-layer structure including the inorganic insulating material. The second insulating layer 112 may be a type of buffer layer that prevents impurities from penetrating into a transistor, for example, the first transistor T1.

A semiconductor layer may be disposed over the second insulating layer 112. In this regard, FIG. 4 illustrates that a first semiconductor layer A1 of the first transistor T1 may be disposed over the second insulating layer 112. The first semiconductor layer A1 may include a channel area CH1, and a source area S1 and a drain area D1 arranged on both sides of the channel area CH1. The first semiconductor layer A1 may include an oxide of at least one selected from indium (In), gallium (Ga), tin (Sn), zirconium (Zr), vanadium (V), hafnium (Hf), cadmium (Cd), germanium (Ge), chromium (Cr), titanium (Ti), aluminium (Al), cesium (Cs), cerium (Ce), and zinc (Zn). For example, the first semiconductor layer A1 may include an InSnZnO (ITZO) semiconductor layer or an InGaZnO (IGZO) semiconductor layer. A conductive (or conductive) process based on, for example, plasma treatment may be performed on at least a portion of the first semiconductor layer A1.

A first gate electrode, for example, a 1st-1 gate electrode G1t, may overlap the channel area CH1 of the first semiconductor layer A1 with a third insulating layer 113 therebetween. The 1st-1 gate electrode G1t may include a conductive material including molybdenum (Mo), aluminium (Al), copper (Cu), titanium (Ti), or a combination thereof and may include a single-layer or multiple-layer structure including the conductive material. The third insulating layer 113 may include an inorganic insulating material such as silicon oxide, silicon nitride, silicon oxynitride, or a combination thereof and may include a single-layer or multiple-layer structure including the inorganic insulating material. The 1st-1 gate electrode G1t may face a 1st-2 gate electrode G1b with the channel area CH1 therebetween. The 1st-2 gate electrode G1b may be the second electrode C22 of the second capacitor C2.

A first upper electrode C11t of the first capacitor C1 may overlap the second electrode C12 with the third insulating layer 113 therebetween and may be electrically connected to the first lower electrode C11b through a contact hole passing through the first, second, and third insulating layers 111, 112, and 113. The first upper electrode C11t of the first capacitor C1 may include a conductive material including molybdenum (Mo), aluminium (Al), copper (Cu), titanium (Ti), or a combination thereof and may include a single-layer or multiple-layer structure including the conductive material.

A fourth insulating layer 114 may be disposed over the first upper electrode C11t of the first capacitor C1 and the 1st-1 gate electrode G1t. The fourth insulating layer 114 may include an inorganic insulating material such as silicon oxide, silicon nitride, silicon oxynitride, or a combination thereof and may include a single-layer or multiple-layer structure including the inorganic insulating material.

A data line DL and a third connection electrode CM3 may be disposed over the fourth insulating layer 114. The data line DL and the third connection electrode CM3 may include a conductive material including molybdenum (Mo), aluminium (Al), copper (Cu), titanium (Ti), or a combination thereof and may include a single-layer or multiple-layer structure including the conductive material.

A fifth insulating layer 115 may be disposed over the data line DL and the third connection electrode CM3 and may include an organic insulating material such as acryl, benzocyclobutene (BCB), polyimide, hexamethyldisiloxane (HMDSO), or a combination thereof.

A driving voltage line PL may be disposed over the fifth insulating layer 115. The driving voltage line PL may include a conductive material including molybdenum (Mo), aluminium (Al), copper (Cu), titanium (Ti), or a combination thereof and may include a single-layer or multiple-layer structure including the conductive material.

A sixth insulating layer 116 may be disposed over the driving voltage line PL and may include an organic insulating material such as acryl, benzocyclobutene (BCB), polyimide, hexamethyldisiloxane (HMDSO), or a combination thereof. Although not illustrated in FIG. 4, another voltage line, for example, a sustain voltage line VSSL (see FIG. 3A) and the driving voltage line PL may be arranged on a same layer, for example, on the fifth insulating layer 115.

The light-emitting diode LED may include a pixel electrode 210, an emission layer 222, and an opposite electrode 230.

The pixel electrode 210 may be disposed over the sixth insulating layer 116. The pixel electrode 210 may include a reflective layer including silver (Ag), magnesium (Mg), aluminium (Al), platinum (Pt), palladium (Pd), gold (Au), nickel (Ni), neodymium (Nd), iridium (Ir), chromium (Cr), any compound thereof, or a combination thereof. In an embodiment, the pixel electrode 210 may further include a conductive oxide layer over and/or under the reflective layer. The conductive oxide layer may include indium tin oxide (ITO), indium zinc oxide (IZO), zinc oxide (ZnO), indium oxide (In2O3), indium gallium oxide (IGO), and/or aluminium zinc oxide (AZO). In an embodiment, the pixel electrode 210 may have a three-layer structure of ITO layer/Ag layer/ITO layer.

A bank layer 123 may be disposed over the pixel electrode 210, and the bank layer 123 may include an opening 123OP overlapping the pixel electrode 210 and may cover the edge of the pixel electrode 210. The bank layer 123 may include an organic insulating material. In some embodiments, the bank layer 123 may include a transparent organic insulating material. In an embodiment, the bank layer 123 may include an organic insulating material including a light blocking material. In some embodiments, the bank layer 123 may include a polyimide (PI)-based binder and a pigment in which red, green, and blue colors may be mixed. The bank layer 123 may include a cardo-based binder resin and a mixture of lactam-based black pigment and blue pigment. The bank layer 123 may include a carbon black. The bank layer 123 may improve the contrast of a display panel.

A spacer 125 may be disposed over the bank layer 123. The spacer 125 may include a different material than the bank layer 123. For example, the bank layer 123 and the spacer 125 may include different materials (e.g., the bank layer 123 may include a negative photosensitive material and the spacer 125 may include a positive photosensitive material) and may be respectively formed through separate mask processes. In an embodiment, the spacer 125 and the bank layer 123 may include a same material and may be formed together in the same mask process (e.g., a halftone mask process).

The emission layer 222 may include a high-molecular weight or low-molecular weight organic material for emitting light of a certain color. The emission layer 222 may include a material for emitting red light, green light, or blue light, depending on the light-emitting diode LED.

A functional layer may be further included under and/or over the emission layer 222. For example, a first functional layer 221 may be further included between the pixel electrode 210 and the emission layer 222, and a second functional layer 223 may be further included between the emission layer 222 and the opposite electrode 230 described below. The first functional layer 221 may include a hole transport layer and/or a hole injection layer. The second functional layer 223 may include an electron transport layer and/or an electron injection layer.

The opposite electrode 230 may include a conductive material having a low work function. For example, the opposite electrode 230 may include a (semi)transparent layer including silver (Ag), magnesium (Mg), aluminium (Al), platinum (Pt), palladium (Pd), gold (Au), nickel (Ni), neodymium (Nd), iridium (Ir), chromium (Cr), lithium (Li), calcium (Ca), any alloy thereof, or a combination thereof. The opposite electrode 230 may further include a layer such as ITO, IZO, ZnO, In2O3, or a combination thereof over the (semi)transparent layer including the above material.

Unlike pixel electrodes 210 separately formed to correspond to light-emitting diodes LED, the opposite electrode 230 may extend to correspond to the pixel electrodes 210. For example, a pixel electrode 210 of a light-emitting diode LED and a pixel electrode 210 of another light-emitting diode LED may be separated and spaced apart from each other, but the opposite electrode 230 overlapping the pixel electrodes 210 may extend to cover the pixel electrodes 210 described above.

An encapsulation layer 300 may be disposed over the light-emitting diode LED and may include at least one inorganic encapsulation layer and at least one organic encapsulation layer. As an embodiment, FIG. 4 illustrates that the encapsulation layer 300 includes a first inorganic encapsulation layer 310, an organic encapsulation layer 320, and a second inorganic encapsulation layer 330.

The first inorganic encapsulation layer 310 and the second inorganic encapsulation layer 330 may include one or more inorganic insulating materials among aluminium oxide, titanium oxide, tantalum oxide, hafnium oxide, zinc oxide, silicon oxide, silicon nitride, and silicon oxynitride. The first inorganic encapsulation layer 310 and the second inorganic encapsulation layer 330 may include a single layer or multiple layers including the above material. The organic encapsulation layer 320 may include a polymer-based material. The polymer-based material may include acryl-based resin, epoxy-based resin, polyimide, polyethylene, or a combination thereof. In an embodiment, the organic encapsulation layer 320 may include acrylate.

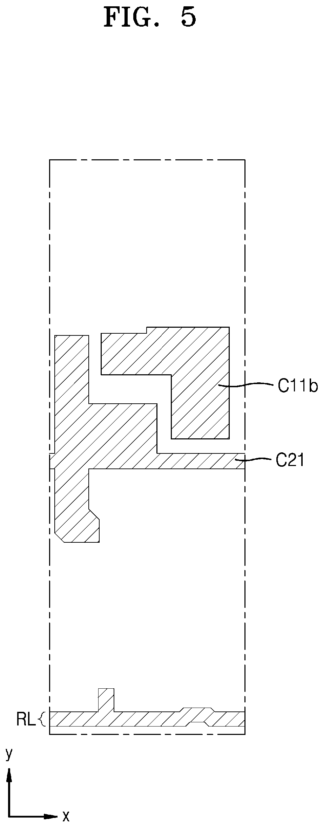

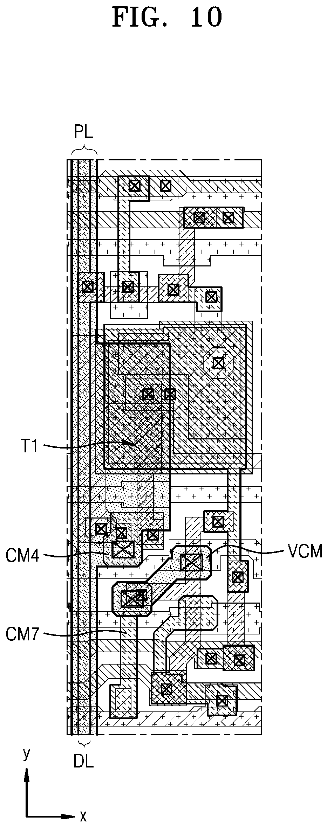

FIGS. 5 to 10 are plan views illustrating a process of forming a pixel circuit included in a display apparatus according to an embodiment. FIG. 10 may correspond to a planar structure of the pixel circuit of the display apparatus described above with reference to FIG. 4.

Referring to FIGS. 4 and 5, a first lower electrode C11b of the first capacitor C1 (see FIG. 4) and a first electrode C21 of the second capacitor C2 (see FIG. 4) may be formed over the substrate 100 (see FIG. 4). The first lower electrode C11b of the first capacitor C1 (see FIG. 4) may have an isolated shape. The first electrode C21 of the second capacitor C2 (FIG. 4) may be spaced apart from the first lower electrode C11b of the first capacitor C1. The first electrode C21 of the second capacitor C2 and a first electrode C21 of a second capacitor C2 of another pixel circuit adjacent thereto in a first direction (e.g., x direction) may be integral with each other.

The first lower electrode C11b of the first capacitor C1 (see FIG. 4) and the first electrode C21 of the second capacitor C2 (see FIG. 4) may include molybdenum (Mo), aluminium (Al), copper (Cu), titanium (Ti), or a combination thereof and may include a single-layer or multiple-layer structure including the aforementioned material.

In some embodiments, a repair line RL, the first lower electrode C11b of the first capacitor C1 (see FIG. 4), and the first electrode C21 of the second capacitor C2 (see FIG. 4) may be disposed on a same layer (e.g., the substrate 100). The repair line RL may extend in the first direction (e.g., x direction) and may be a type of spare line that may be used in the case that a defect occurs in a signal line or a voltage line included in the pixel circuit.

A first insulating layer 111 (see FIG. 4) may be formed over the structure illustrated in FIG. 5, for example, over the first lower electrode C11b of the first capacitor C1 (see FIG. 4) and the first electrode C21 of the second capacitor C2 (see FIG. 4) and the repair line RL.

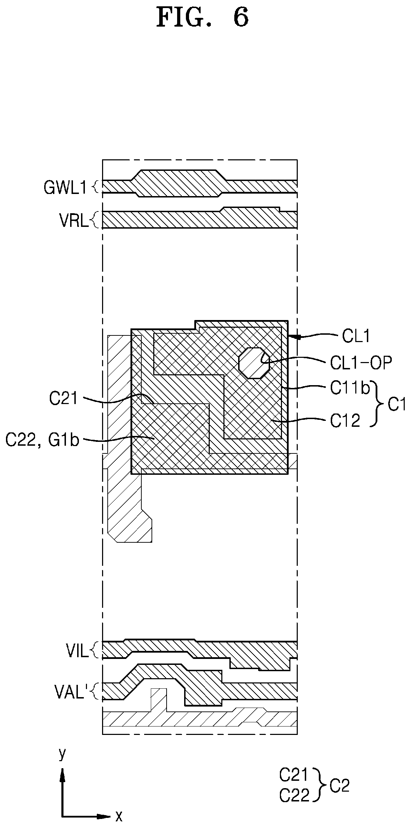

Referring to FIGS. 4 and 6, a first conductive layer CL1, a 1st-1 gate line GWL1, a reference voltage line VRL, a first initialization voltage line VAL', and a second initialization voltage line VIL may be arranged over the first insulating layer 111 (see FIG. 4). The first conductive layer CL1 may have an isolated shape, and the 1st-1 gate line GWL1, the reference voltage line VRL, the first initialization voltage line VAL', and the second initialization voltage line VIL may extend in the first direction (e.g., x direction).

The first conductive layer CL1, the 1st-1 gate line GWL1, the reference voltage line VRL, the first initialization voltage line VAL', and the second initialization voltage line VIL may include molybdenum (Mo), aluminium (Al), copper (Cu), titanium (Ti), or a combination thereof and may include a single-layer or multiple-layer structure including the aforementioned material.

The first conductive layer CL1 may overlap the first lower electrode C11b of the first capacitor C1 (see FIG. 4) and the first electrode C21 of the second capacitor C2 (see FIG. 4). The first conductive layer CL1 may include second electrodes C12 and C22 of the first and second capacitors C1 and C2. For example, a portion of the first conductive layer CL1 may be the second electrode C12 of the first capacitor C1 overlapping the first lower electrode C11b of the first capacitor C1, and another portion thereof may be the second electrode C22 of the second capacitor C2 overlapping the first electrode C21 of the second capacitor C2.

The first conductive layer CL1 may include the 1st-2 gate electrode G1b of the first transistor T1 (see FIG. 4) overlapping the channel area CH1 (see FIG. 4) of the first transistor T1 (see FIG. 4). For example, a portion of the first conductive layer CL1 corresponding to the second electrode C22 of the second capacitor C2 may correspond to the 1st-2 gate electrode G1b of the first transistor T1 (see FIG. 4). The 1st-2 gate electrode G1b may correspond to the 1st-2 gate (or the 1st-2 gate electrode) described above with reference to FIGS. 3A and 3B.

The first conductive layer CL1 may include an opening CL1-OP. The opening CL1-OP may overlap the first lower electrode C11b of the first capacitor C1.

The 1st-1 gate line GWL1 may be arranged on a side of the first conductive layer CL1, for example, on the upper side of the first conductive layer CL1 in the plan view of FIG. 6. The reference voltage line VRL may be arranged on a side of the first conductive layer CL1, for example, on the upper side of the first conductive layer CL1, in the plan view of FIG. 6. The reference voltage line VRL may be located between the 1st-1 gate line GWL1 and the first conductive layer CL1.

The first initialization voltage line VAL' and the second initialization voltage line VIL may be arranged on another side of the first conductive layer CL1, for example, on the lower side of the first conductive layer CL1 in the plan view of FIG. 6. In some embodiments, the second initialization voltage line VIL may be arranged between the first conductive layer CL1 and the first initialization voltage line VAL'.

A second insulating layer 112 (see FIG. 4) may be formed over the structure illustrated in FIG. 6, for example, over the first conductive layer CL1, the 1st-1 gate line GWL1, the reference voltage line VRL, the first initialization voltage line VAL', and the second initialization voltage line VIL.

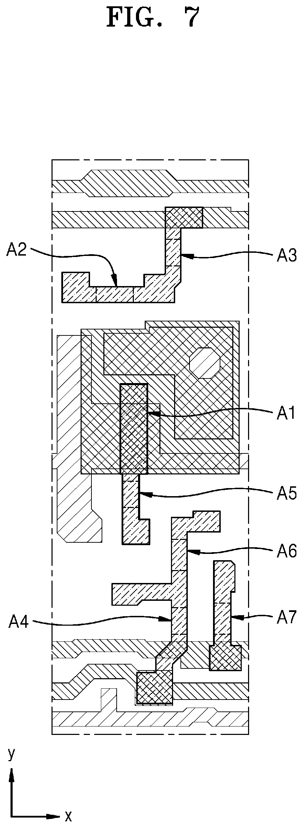

Referring to FIGS. 4 and 7, first to seventh semiconductor layers A1, A2, A3, A4, A5, A6, and A7 may be formed over the second insulating layer 112 (see FIG. 4). The first to seventh semiconductor layers A1, A2, A3, A4, A5, A6, and A7 may include a same material. For example, the first to seventh semiconductor layers A1, A2, A3, A4, A5, A6, and A7 may include an oxide of at least one of indium (In), gallium (Ga), tin (Sn), zirconium (Zr), vanadium (V), hafnium (Hf), cadmium (Cd), germanium (Ge), chromium (Cr), titanium (Ti), aluminium (Al), cesium (Cs), cerium (Ce), and zinc (Zn). In other embodiments, the first to seventh semiconductor layers A1, A2, A3, A4, A5, A6, and A7 may include polysilicon, amorphous silicon, or the like.

The second semiconductor layer A2 and the third semiconductor layer A3 may be integral with each other, and the fourth semiconductor layer A4 and the sixth semiconductor layer A6 may also be integral with each other. The first semiconductor layer A1 and the fifth semiconductor layer A5 may be integral with each other. The first semiconductor layer A1 may be arranged adjacent to the second semiconductor layer A2 and the third semiconductor layer A3 and they may be separated and spaced apart from each other. The fifth semiconductor layer A5 may be arranged adjacent to the sixth semiconductor layer A6 and they may be separated and spaced apart from each other, and the seventh semiconductor layer A7 may be arranged adjacent to the fourth semiconductor layer A4 and the sixth semiconductor layer A6 and they may be separated and spaced apart from each other.

A third insulating layer 113 (see FIG. 4) may be formed over the structure illustrated in FIG. 7, for example, over the first to seventh semiconductor layers A1, A2, A3, A4, A5, A6, and A7.

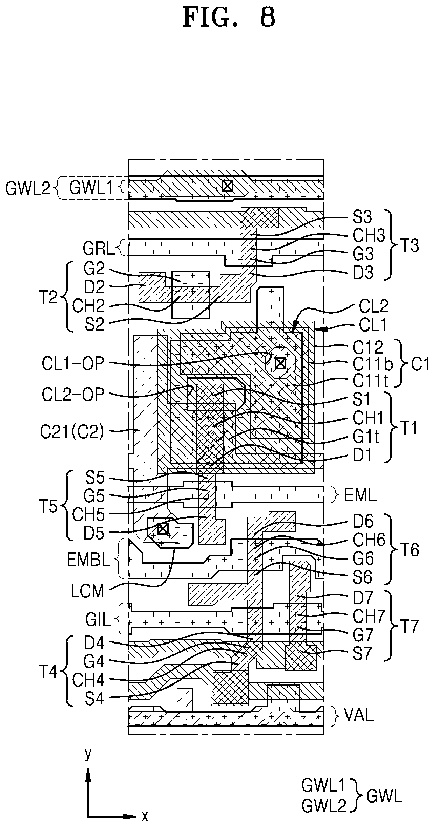

Referring to FIGS. 4 and 8, a second conductive layer CL2, a second gate electrode G2, a 1st-2 gate line GWL2, a second gate line GRL, a third gate line EML, a fourth gate line GIL, a fifth gate line EMBL, a first initialization voltage line VAL, and a lower connection electrode LCM may be formed over the structure illustrated in FIG. 7, for example, over the first to seventh semiconductor layers A1, A2, A3, A4, A5, A6, and A7. The second conductive layer CL2, the second gate electrode G2, and the lower connection electrode LCM may have an isolated shape. Each of the 1st-2 gate line GWL2, the second gate line GRL, the third gate line EML, the fourth gate line GIL, the fifth gate line EMBL, and the first initialization voltage line VAL may extend in the first direction (e.g., x direction).

The second conductive layer CL2, the second gate electrode G2, the 1st-2 gate line GWL2, the second gate line GRL, the third gate line EML, the fourth gate line GIL, the fifth gate line EMBL, the first initialization voltage line VAL, and the lower connection electrode LCM may include a same material. For example, the second conductive layer CL2, the second gate electrode G2, the 1st-2 gate line GWL2, the second gate line GRL, the third gate line EML, the fourth gate line GIL, the fifth gate line EMBL, the first initialization voltage line VAL, and the lower connection electrode LCM may include molybdenum (Mo), aluminium (Al), copper (Cu), titanium (Ti), or a combination thereof and may include a single-layer or multiple-layer structure including the aforementioned material.

The second conductive layer CL2 may overlap the first conductive layer CL1. In other words, the second conductive layer CL2 may overlap the first lower electrode C11b, the second electrode C12 (FIG. 6) included in the first conductive layer CL1, and the channel area CH1 of the first transistor T1. The second conductive layer CL2 may include the first upper electrode C11t of the first capacitor C1 overlapping the second electrode C12 (see FIG. 6) included in the first conductive layer CL1. The first upper electrode C11t of the first capacitor C1 may be electrically connected to the first lower electrode C11b of the first capacitor C1 through a contact hole and the opening CL1-OP of the first conductive layer CL1 disposed thereunder. The first upper electrode C11t and the first lower electrode C11b may correspond to the first electrode of the first capacitor C1 electrically connected to the first node N1 described above with reference to FIGS. 3A and 3B.

The second conductive layer CL2 may include the 1st-1 gate electrode G1t of the first transistor T1. The 1st-1 gate electrode G1t may overlap the 1st-2 gate electrode G1b (see FIG. 6) with the channel area CH1 therebetween. The 1st-1 gate electrode G1t may be a gate involved in turning on and off the first transistor T1, and herein, the first gate electrode of the first transistor T1 may refer to the 1st-1 gate electrode G1t.

The first semiconductor layer A1 (see FIG. 7) described with reference to FIG. 7 may include a channel area CH1 of the first transistor T1, a source area S1 arranged on a side of the channel area CH1, and a drain area D1 arranged on another side of the channel area CH1. The source area S1 of the first transistor T1 may overlap an opening CL2-OP of the second conductive layer CL2.

The second gate electrode G2 may be arranged adjacent to the second conductive layer CL2. The second gate electrode G2 may overlap the channel area CH2 of the second transistor T2. The second semiconductor layer A2 (see FIG. 7) described with reference to FIG. 7 may include a channel area CH2 of the second transistor T2, a source area S2 arranged on a side of the channel area CH2, and a drain area D2 arranged on another side of the channel area CH2.

The 1st-2 gate line GWL2 may be arranged on a side of the second conductive layer CL2, for example, on the upper side of the second conductive layer CL2, in the plan view of FIG. 8. The 1st-2 gate line GWL2 may overlap the 1st-1 gate line GWL1 and may be electrically connected to the 1st-1 gate line GWL1 through a contact hole. The first gate line GWL may include the 1st-2 gate line GWL2 and the 1st-1 gate line GWL1 electrically connected to each other. By including a connection structure of multiple sublines as such, the resistance of the first gate line GWL may be reduced.

The second gate line GRL may be arranged on a side of the second conductive layer CL2, for example, on the upper side of the second conductive layer CL2, in the plan view of FIG. 8. The second gate line GRL may be located between the 1st-2 gate line GWL2 and the second conductive layer CL2. The second gate line GRL may include a third gate electrode G3 overlapping a channel area CH3 of the third transistor T3. The third semiconductor layer A3 (see FIG. 7) described with reference to FIG. 7 may include a channel area CH3 of the third transistor T3, a source area S3 arranged on a side of the channel area CH3, and a drain area D3 arranged on another side of the channel area CH3.

The third gate line EML, the fourth gate line GIL, the fifth gate line EMBL, and the first initialization voltage line VAL may be arranged on another side of the first conductive layer CL1, for example, on the lower side of the second conductive layer CL2, in the plan view of FIG. 8.

The third gate line EML may include a fifth gate electrode G5 overlapping a channel area CH5 of the fifth transistor T5. The fifth semiconductor layer A5 (see FIG. 7) described with reference to FIG. 7 may include a channel area CH5 overlapping the fifth gate electrode G5, a source area S5 arranged on a side of the channel area CH5, and a drain area D5 arranged on another side of the channel area CH5.

The fourth gate line GIL may include fourth and seventh gate electrodes G4 and G7 overlapping channel areas CH4 and CH7 of the fourth and seventh transistors T4 and T7, respectively. The fourth semiconductor layer A4 (see FIG. 7) described with reference to FIG. 7 may include a channel area CH4 overlapping the fourth gate electrode G4, a source area S4 arranged on a side of the channel area CH4, and a drain area D4 arranged on another side of the channel area CH4. The seventh semiconductor layer A7 (see FIG. 7) described with reference to FIG. 7 may include a channel area CH7 overlapping the seventh gate electrode G7, a source area S7 arranged on a side of the channel area CH7, and a drain area D7 arranged on another side of the channel area CH7.

The fifth gate line EMBL may include a sixth gate electrode G6 overlapping a channel area CH6 of the sixth transistor T6. The sixth semiconductor layer A6 (see FIG. 7) described with reference to FIG. 7 may include a channel area CH6 overlapping the sixth gate electrode G6, a source area S6 arranged on a side of the channel area CH6, and a drain area D6 arranged on another side of the channel area CH6.

The first initialization voltage line VAL may be arranged relatively far away from the second conductive layer CL2. In some embodiments, the third gate line EML, the fourth gate line GIL, and the fifth gate line EMBL may be arranged between the first initialization voltage line VAL and the second conductive layer CL2.

The lower connection electrode LCM may be electrically connected to a portion of the first electrode C21 of the second capacitor C2.

A fourth insulating layer 114 (see FIG. 4) may be formed over the structure illustrated in FIG. 8, for example, over the second conductive layer CL2, the second gate electrode G2, the 1st-2 gate line GWL2, the second gate line GRL, the third gate line EML, the fourth gate line GIL, the fifth gate line EMBL, the first initialization voltage line VAL, and the lower connection electrode LCM.

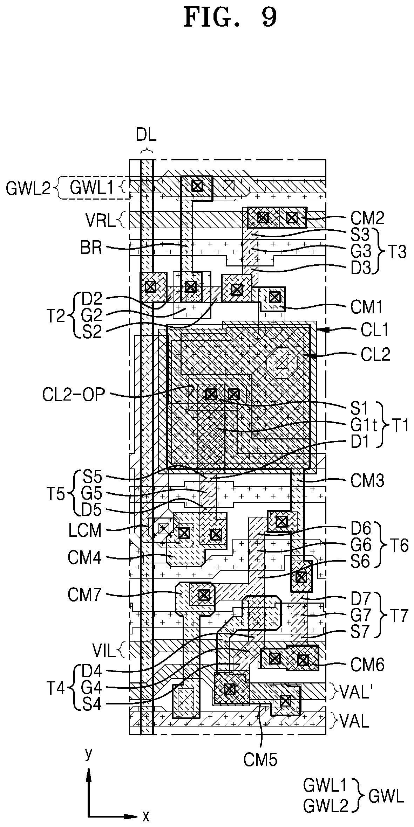

Referring to FIGS. 4 and 9, a data line DL, a bridge electrode BR, and first to seventh connection electrodes CM1, CM2, CM3, CM4, CM5, CM6, and CM7 may be formed over the fourth insulating layer 114 (see FIG. 4).

The data line DL, the bridge electrode BR, and the first to seventh connection electrodes CM1, CM2, CM3, CM4, CM5, CM6, and CM7 may include a same material. The data line DL, the bridge electrode BR, and the first to seventh connection electrodes CM1, CM2, CM3, CM4, CM5, CM6, and CM7 may include molybdenum (Mo), aluminium (Al), copper (Cu), titanium (Ti), or a combination thereof and may include a single-layer or multiple-layer structure including the aforementioned material.

The data line DL may extend in a second direction (e.g., y direction) intersecting the first direction (e.g., x direction). The data line DL may be electrically connected to the drain area D2 of the second transistor T2 through a contact hole 41a passing through at least one insulating layer arranged between the data line DL and the drain area D2 of the second transistor T2.

The bridge electrode BR may electrically connect the first gate line GWL and the second gate electrode G2 to each other. The first gate line GWL may include a 1st-1 gate line GWL1 and a 1st-2 gate line GWL2 electrically connected to the 1st-1 gate line GWL1, and a portion of the bridge electrode BR may be electrically connected to the 1st-2 gate line GWL2 through a contact hole 42a passing through at least one insulating layer arranged between the 1st-2 gate line GWL2 and the bridge electrode BR. Another portion of the bridge electrode BR may be electrically connected to the second gate electrode G2 through a contact hole 43a passing through at least one insulating layer arranged between the second gate electrode G2 and the bridge electrode BR.

The first connection electrode CM1 may be electrically connected to the first gate electrode (e.g., the 1st-1 gate electrode G1t) of the first transistor T1, the first upper electrode C11t of the first capacitor C1 (see FIG. 8), the third semiconductor layer of the third transistor T3, and the second semiconductor layer of the second transistor T2. For example, the first connection electrode CM1 may electrically connect the second conductive layer CL2 including the first gate electrode (e.g., the 1st-1 gate electrode G1t) and the first upper electrode C11t of the first capacitor C1 (see FIG. 8), the drain area D3 of the third transistor T3, and the source area S2 of the second transistor T2.

The first connection electrode CM1 may be electrically connected to the drain area D3 of the third transistor T3 and the source area S2 of the second transistor T2 through a contact hole passing through at least one insulating layer arranged between the first connection electrode CM1 and the drain area D3 of the third transistor T3 and the source area S2 of the second transistor T2. The first connection electrode CM1 may be electrically connected to the second conductive layer CL2 through a contact hole passing through at least one insulating layer arranged between the first connection electrode CM1 and the second conductive layer CL2.

The second connection electrode CM2 may electrically connect the third semiconductor layer of the third transistor T3 and the reference voltage line VRL to each other. The second connection electrode CM2 may be electrically connected to the source area S3 of the third transistor T3 through a contact hole passing through at least one insulating layer arranged between the second connection electrode CM2 and the source area S3 of the third transistor T3. The second connection electrode CM2 may be electrically connected to the reference voltage line VRL through a contact hole passing through at least one insulating layer arranged between the second connection electrode CM2 and the reference voltage line VRL.

The third connection electrode CM3 may overlap the second conductive layer CL2 and may be electrically connected to the source area S1 of the first transistor T1 through an opening CL1-OP of the second conductive layer CL2 and a contact hole passing through at least one insulating layer arranged between the third connection electrode CM3 and the first semiconductor layer of the first transistor T1. The third connection electrode CM3 may be electrically connected to the first conductive layer CL1 through an opening CL1-OP of the second conductive layer CL2 and a contact hole passing through at least one insulating layer arranged between the first conductive layer CL1 and the third connection electrode CM3. The third connection electrode CM3 may be electrically connected to the drain area D7 of the seventh transistor T7 through a contact hole passing through at least one insulating layer arranged between the seventh semiconductor layer of the seventh transistor T7 and the third connection electrode CM3. The third connection electrode CM3 may be electrically connected to the drain area D6 of the sixth transistor T6 through a contact hole passing through at least one insulating layer arranged between the sixth semiconductor layer of the sixth transistor T6 and the third connection electrode CM3.

The fourth connection electrode CM4 may electrically connect the fifth semiconductor layer of the fifth transistor T5 and the lower connection electrode LCM to each other. The fourth connection electrode CM4 may be electrically connected to the drain area D5 of the fifth transistor T5 through a contact hole passing through at least one insulating layer arranged between the fourth connection electrode CM4 and the drain area D5 of the fifth transistor T5. The fourth connection electrode CM4 may be electrically connected to the lower connection electrode LCM through a contact hole passing through at least one insulating layer arranged between the fourth connection electrode CM4 and the lower connection electrode LCM.

The fifth connection electrode CM5 may electrically connect the fourth semiconductor layer of the fourth transistor T4 and the first initialization voltage line VAL to each other. The fifth connection electrode CM5 may be electrically connected to the source area S4 of the fourth transistor T4 through a contact hole passing through at least one insulating layer arranged between the source area S4 of the fourth transistor T4 and the fifth connection electrode CM5. The fifth connection electrode CM5 may be electrically connected to the first initialization voltage line VAL through a contact hole passing through at least one insulating layer arranged between the first initialization voltage line VAL and the fifth connection electrode CM5.

One of the two first initialization voltage lines VAL and VAL' arranged adjacent to each other may be electrically connected to the pixel circuit electrically connected to the light-emitting diode emitting light of a first color. Also, the other one of the two first initialization voltage lines VAL and VAL' may be electrically connected to the pixel circuits electrically connected to the light-emitting diodes emitting light of colors (e.g., a second color and a third color) different from the first color. In this regard, FIG. 9 illustrates the pixel circuit including the fourth transistor T4 electrically connected to the first initialization voltage line VAL, and the pixel circuit illustrated in FIG. 9 may be electrically connected to the light-emitting diode emitting light of the first color.

The sixth connection electrode CM6 may electrically connect the seventh semiconductor layer of the seventh transistor T7 and the second initialization voltage line VIL to each other. The sixth connection electrode CM6 may be electrically connected to the source area S7 of the seventh transistor T7 through a contact hole passing through at least one insulating layer arranged between the source area S7 of the seventh transistor T7 and the sixth connection electrode CM6. The sixth connection electrode CM6 may be electrically connected to the second initialization voltage line VIL through a contact hole passing through at least one insulating layer arranged between the second initialization voltage line VIL and the sixth connection electrode CM6.

The seventh connection electrode CM7 may be electrically connected to the fourth and sixth semiconductor layers of the fourth and sixth transistors T4 and T6. The seventh connection electrode CM7 may be electrically connected to the drain area D4 of the fourth transistor T4 and the source area S6 of the sixth transistor T6 through a contact hole passing through at least one insulating layer arranged between the fourth and sixth semiconductor layers and the seventh connection electrode CM7.

A fifth insulating layer 115 (see FIG. 4) may be formed over the structure illustrated in FIG. 9, for example, over the data line DL, the bridge electrode BR, and the first to seventh connection electrodes CM1, CM2, CM3, CM4, CM5, CM6, and CM7.

Referring to FIGS. 4 and 10, a driving voltage line PL and a via connection electrode VCM may be formed. The driving voltage line PL and the via connection electrode VCM may include a same material. The driving voltage line PL and the via connection electrode VCM may include molybdenum (Mo), aluminium (Al), copper (Cu), titanium (Ti), or a combination thereof and may include a single-layer or multiple-layer structure including the aforementioned material.

The driving voltage line PL may extend in the second direction (e.g., y direction). In some embodiments, the driving voltage line PL may overlap the data line DL and may overlap the first transistor T1. The driving voltage line PL may be electrically connected to the fourth connection electrode CM4 through a contact hole passing through at least one insulating layer arranged between the fourth connection electrode CM4 and the driving voltage line PL.

The via connection electrode VCM may be electrically connected to the seventh connection electrode CM7. The via connection electrode VCM may be electrically connected to the seventh connection electrode CM7 through a contact hole passing through an insulating layer between the seventh connection electrode CM7 and the via connection electrode VCM. The via connection electrode VCM may be electrically connected to a pixel electrode of a light-emitting diode (e.g., a first-color light-emitting diode) that may be electrically connected to the pixel circuit illustrated in FIG. 10.

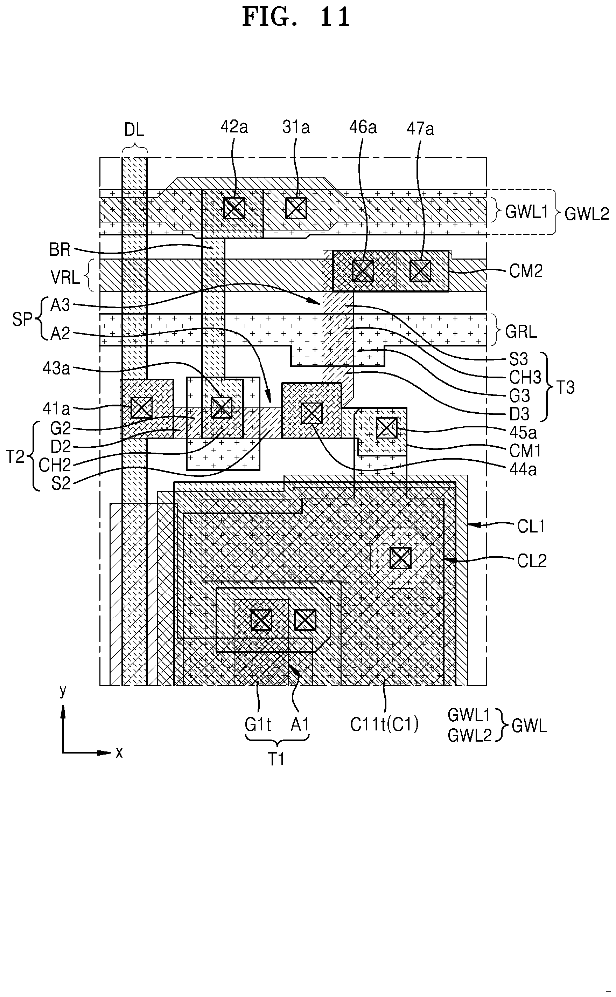

FIG. 11 is a plan view illustrating a portion of a pixel circuit according to an embodiment. FIG. 11 may correspond to, for example, a plan view illustrating a portion of the pixel circuit described with reference to FIGS. 5 to 10.

Referring to FIG. 11, the first gate line GWL and the second gate line GRL may extend in the first direction (e.g., x direction). The reference voltage line VRL may extend in the first direction (e.g., x direction). The reference voltage line VRL may be arranged between the first gate line GWL and the second gate line GRL. The data line DL may extend in the second direction (e.g., y direction) intersecting the first direction (e.g., x direction).

The semiconductor pattern SP may be arranged apart from the first gate line GWL and the first semiconductor layer A1. The semiconductor pattern SP may include the second semiconductor layer A2 and the third semiconductor layer A3. In other words, the second semiconductor layer A2 and the third semiconductor layer A3 may be arranged along the semiconductor pattern SP as a portion of the semiconductor pattern SP that may be a single body.

The semiconductor pattern SP may have a bent shape. For example, the semiconductor pattern SP may include the second semiconductor layer A2 extending in the first direction (e.g., x direction) and the third semiconductor layer A3 extending in the second direction (e.g., y direction) around the bent point.

The second semiconductor layer A2 may be spaced apart from the first gate line GWL by a certain distance without overlapping the first gate line GWL. The second gate line GRL and the reference voltage line VRL may be located in the space between the first gate line GWL and the second semiconductor layer A2. The second semiconductor layer A2 may include a channel area CH2, and a source area S2 and a drain area D2 on both sides of the channel area CH2.

The channel area CH2 of the second transistor T2 may overlap the second gate electrode G2. The second gate electrode G2 may have an isolated shape and may be spaced apart from the first gate line GWL by a certain distance without overlapping the first gate line GWL. The second gate electrode G2 may be electrically connected to the first gate line GWL by the bridge electrode BR extending in the second direction (e.g., y direction). The bridge electrode BR may electrically connect the first gate line GWL and the second gate electrode G2 to each other through contact holes 42a and 43a.

In some embodiments, the first gate line GWL may include a 1st-1 gate line GWL1 and a 1st-2 gate line GWL2 that may be electrically connected through a contact hole 31a. The bridge electrode BR may be electrically connected to the 1st-2 gate line GWL2 arranged on the upper side among the 1st-1 gate line GWL1 and the 1st-2 gate line GWL2.

One of the source area S2 and the drain area D2 of the second transistor T2 may be electrically connected to the data line DL. For example, the data line DL may be electrically connected through a contact hole 41a to a portion of the second semiconductor layer A2, for example, the drain area D2 of the second semiconductor layer A2. The other one of the source area S2 and the drain area D2 of the second transistor T2 may be electrically connected to the third semiconductor layer A3. For example, the source area S2 of the second semiconductor layer A2 and the drain area D3 of the third semiconductor layer A3 may be integral with each other.

The third semiconductor layer A3 may overlap the second gate line GRL. The third semiconductor layer A3 may include a channel area CH3 overlapping the second gate line GRL and a source area S3 and a drain area D3 arranged on both sides of the channel area CH3 in the second direction (e.g., y direction). A portion of the second gate line GRL may correspond to the third gate electrode G3.

One of the source area S3 and the drain area D3 of the third semiconductor layer A3 may be electrically connected to the reference voltage line VRL. For example, the reference voltage line VRL and the source area S3 of the third semiconductor layer A3 may be electrically connected through the second connection electrode CM2. The second connection electrode CM2 may be electrically connected to the source area S3 of the third semiconductor layer A3 and the reference voltage line VRL through contact holes 46a and 47a.

The drain area D3 of the third semiconductor layer A3 may be electrically connected to the source area S2 of the second semiconductor layer A2 as described above. The second and third semiconductor layers A2 and A3 that are integral with each other may be electrically connected to the 1st-1 gate electrode G1t of the first transistor T1 and the electrode (e.g., the first upper electrode C11t) of the first capacitor C1 through the first connection electrode CM1. In this regard, FIG. 11 illustrates that the second conductive layer CL2 includes the 1st-1 gate electrode G1t of the first transistor T1 and the electrode (e.g., the first upper electrode C11t) of the first capacitor C1 and the second and third semiconductor layers A2 and A3 that are integral with each other may be electrically connected to the second conductive layer CL2 through the first connection electrode CM1. The first connection electrode CM1 may be arranged apart from the first gate line GWL so as not to overlap the first gate line GWL.

In other words, the semiconductor pattern SP including the second semiconductor layer A2 and the third semiconductor layer A3 may be electrically connected to the 1st-1 gate electrode G1t of the first transistor T1 and the electrode (e.g., the first upper electrode C11t) of the first capacitor C1 through the first connection electrode CM1.

A bent portion of the semiconductor pattern SP may include the source area S2 of the second transistor T2 and the drain area D3 of the third transistor T3, and the first connection electrode CM1 may be electrically connected to the bent portion of the semiconductor pattern SP through a contact hole 44a. The first connection electrode CM1 may be electrically connected through a contact hole 45a to the second conductive layer CL2, for example, the 1st-1 gate electrode G1t of the first transistor T1 and the electrode (e.g., the first upper electrode C11t) of the first capacitor C1.

The bent portion of the semiconductor pattern SP may be located between the channel area CH2 of the second semiconductor layer A2 and the channel area CH3 of the third semiconductor layer A3. Both end portions of the semiconductor pattern SP, for example, both end portions thereof with the channel area CH2 of the second semiconductor layer A2 and the channel area CH3 of the third semiconductor layer A3 therebetween, may be respectively electrically connected to the data line DL and the reference voltage line VRL. The connection portion between the data line DL and the semiconductor pattern SP and the connection portion between the reference voltage line VRL and the semiconductor pattern SP may be located at opposite sides with the channel area CH2 of the second semiconductor layer A2 and the channel area CH3 of the third semiconductor layer A3 therebetween.

Through the structure illustrated in FIG. 11, the component(s) electrically connected to the 1st-1 gate electrode G1t of the first transistor T1 may not overlap the first gate line GWL, and thus, an undesired parasitic capacitance may be prevented from occurring between the aforementioned component(s) and the first gate line GWL. For example, because the first connection electrode CM1 does not overlap the first gate line GWL, a parasitic capacitance may be prevented from occurring between the first node N1 (see FIGS. 3A and 3B) and the first gate line GWL described above with reference to FIGS. 3A and 3B. For example, the parasitic capacitance between the first connection electrode CM1 and the first gate line GWL may be prevented.

As a comparative example of the disclosure, in the case where a parasitic capacitance occurs between the first node N1 (see FIGS. 3A and 3B) and the first gate line GWL, in the case that the gate signal transmitted through the first gate line GWL changes (from high level to low level or from low level to high level), the voltage of the pixel PX (see FIG. 2) may change undesirably and thus spots may occur locally in the display area. However, the disclosure may prevent or minimize the degradation of the display quality, such as the above spots, through the above structure.

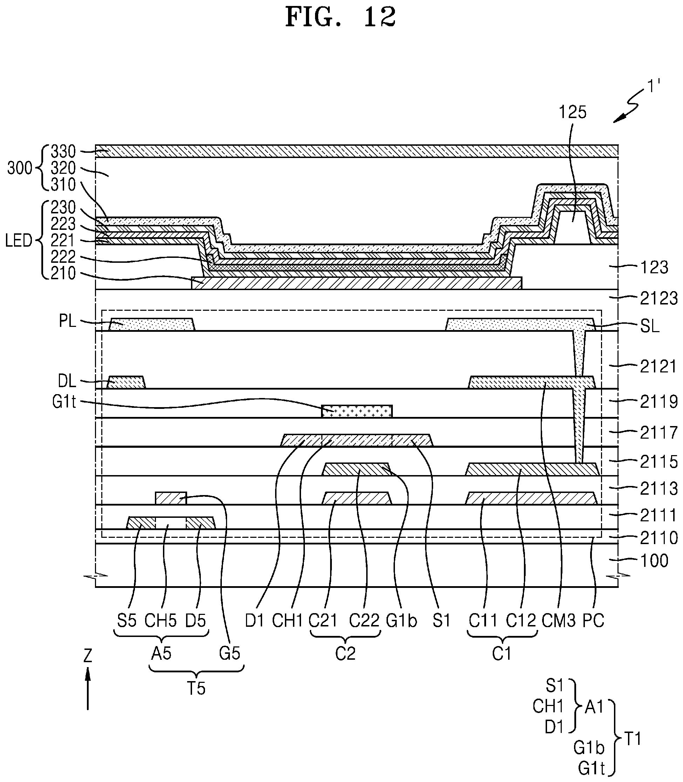

FIG. 12 is a cross-sectional view schematically illustrating a display apparatus according to an embodiment.

Referring to FIG. 12, a display apparatus 1' may include a light-emitting diode LED arranged in a display area DA. The light-emitting diode LED may be disposed over the substrate 100, and a pixel circuit PC may be arranged between the substrate 100 and the light-emitting diode LED. As an embodiment, FIG. 12 illustrates a first transistor T1, a fifth transistor T5, a first capacitor C1, and a second capacitor C2 as some components of the pixel circuit PC.

The substrate 100 may include a glass material or a polymer resin. In an embodiment, the substrate 100 may have an alternating stack structure of a base layer including a polymer resin and a barrier layer including an inorganic insulating material such as silicon oxide or silicon nitride. The polymer resin may include a polymer resin such as polyether sulfone, polyarylate, polyether imide, polyethylene naphthalate, polyethylene terephthalate, polyphenylene sulfide, polyimide, polycarbonate, cellulose triacetate, cellulose acetate propionate, or a combination thereof.

A first insulating layer 2110 may be disposed over the substrate 100. The first insulating layer 2110 may include an inorganic insulating material such as silicon oxide, silicon nitride, silicon oxynitride, or a combination thereof and may include a single-layer or multiple-layer structure including the inorganic insulating material.

The fifth transistor T5 may be disposed over the first insulating layer 2110. The fifth transistor T5 may include a fifth semiconductor layer A5 including a channel area CH5, and a source area S5 and a drain area D5 arranged on both sides of the channel area CH5, and a fifth gate electrode G5 overlapping the channel area CH5. The fifth semiconductor layer A5 may include amorphous silicon or polysilicon, and the source area S5 and the drain area D5 may be areas doped with dopant. The fifth gate electrode G5 may include molybdenum (Mo), aluminium (Al), copper (Cu), titanium (Ti), or a combination thereof and may include a single-layer or multiple-layer structure including the aforementioned material.

A second insulating layer 2111 may be a type of gate insulating layer and may be arranged between the fifth semiconductor layer A5 and the fifth gate electrode G5. The second insulating layer 2111 may include an inorganic insulating material such as silicon oxide, silicon nitride, or silicon oxynitride and may include a single-layer or multiple-layer structure including the inorganic insulating material.

First electrodes C11 and C21 of the first capacitor C1 and the second capacitor C2 may be disposed over the second insulating layer 2111. The first electrodes C11 and C21 of the first capacitor C1, the second capacitor C2, and the fifth gate electrode G5 may include a same material.

A third insulating layer 2113 may be disposed over the first electrodes C11 and C21 of the first capacitor C1 and the second capacitor C2 respectively. The third insulating layer 2113 may include an inorganic insulating material such as silicon oxide, silicon nitride, or silicon oxynitride and may include a single-layer or multiple-layer structure including the inorganic insulating material. The third insulating layer 2113 may be a type of dielectric layer arranged between the first electrodes C11 and C21 of the first and second capacitors C1 and C2 respectively and second electrodes C12 and C22 respectively described below.

Second electrodes C12 and C22 of the first capacitor C1 and the second capacitor C2 respectively may be disposed over the third insulating layer 2113. The second electrodes C12 and C22 of the first capacitor C1 and the second capacitor C2 respectively may include a conductive material such as a metal, such as molybdenum (Mo), aluminium (Al), copper (Cu), titanium (Ti), or a combination thereof and may include a single-layer or multiple-layer structure including the conductive material.

A fourth insulating layer 2115 may be disposed over the second electrodes C12 and C22 of the first capacitor C1 and the second capacitor C2 respectively. The fourth insulating layer 2115 may include an inorganic insulating material such as silicon oxide, silicon nitride, silicon oxynitride, or a combination thereof and may include a single-layer or multiple-layer structure including the inorganic insulating material.

A first semiconductor layer A1 of the first transistor T1 may be disposed over the fourth insulating layer 2115. The first semiconductor layer A1 may include a channel area CH1, and a source area S1 and a drain area D1 arranged on both sides of the channel area CH1. The first semiconductor layer A1 may include an oxide of at least one of indium (In), gallium (Ga), tin (Sn), zirconium (Zr), vanadium (V), hafnium (Hf), cadmium (Cd), germanium (Ge), chromium (Cr), titanium (Ti), aluminium (Al), cesium (Cs), cerium (Ce), and zinc (Zn). For example, the first semiconductor layer A1 may include an InSnZnO (ITZO) semiconductor layer or an InGaZnO (IGZO) semiconductor layer. At least a portion of the first semiconductor layer A1, for example, the source area S1 and the drain area D1, may be a conductive area formed by plasma treatment or the like.

A first gate electrode G1 of the first transistor T1 may include a 1st-1 gate electrode G1t disposed over the channel area CH1 of the first semiconductor layer A1 with a fifth insulating layer 2117 therebetween, and a 1st-2 gate electrode G1b facing the 1st-1 gate electrode G1t with the channel area CH1 therebetween. The 1st-1 gate electrode G1t may include a conductive material including molybdenum (Mo), aluminium (Al), copper (Cu), titanium (Ti), or a combination thereof and may include a single-layer or multiple-layer structure including the conductive material. The 1st-2 gate electrode G1b may include the second electrode C22 of the second capacitor C2. In other words, the second electrode C22 of the second capacitor C2 may include the 1st-2 gate electrode G1b. The fifth insulating layer 2117 may include an inorganic insulating material such as silicon oxide, silicon nitride, silicon oxynitride, or a combination thereof and may include a single-layer or multiple-layer structure including the inorganic insulating material.

A sixth insulating layer 2119 may be disposed over the first transistor T1, for example, over the 1st-1 gate electrode G1t. The sixth insulating layer 2119 may include an inorganic insulating material such as silicon oxide, silicon nitride, silicon oxynitride, or a combination thereof and may include a single-layer or multiple-layer structure including the inorganic insulating material.

A data line DL and a third connection electrode CM3 may be disposed over the sixth insulating layer 2119. The data line DL and the third connection electrode CM3 may include a conductive material including molybdenum (Mo), aluminium (Al), copper (Cu), titanium (Ti), or a combination thereof and may include a single-layer or multiple-layer structure including the conductive material.

A seventh insulating layer 2121 may be disposed over the data line DL and the third connection electrode CM3 and may include an organic insulating material such as acryl, benzocyclobutene (BCB), polyimide, hexamethyldisiloxane (HMDSO), or a combination thereof.

A driving voltage line PL and the cover layer SL may be disposed over the seventh insulating layer 2121. The driving voltage line PL and the cover layer SL may include a conductive material including molybdenum (Mo), aluminium (Al), copper (Cu), titanium (Ti), or a combination thereof and may include a single-layer or multiple-layer structure including the conductive material.

An eighth insulating layer 2123 may be disposed over the driving voltage line PL and the cover layer SL and may include an organic insulating material such as acryl, benzocyclobutene (BCB), polyimide, hexamethyldisiloxane (HMDSO), or a combination thereof.

Although not illustrated in FIG. 12, another voltage line, for example, a sustain voltage line VSSL (see FIG. 3B) and the driving voltage line PL may be disposed on a same eighth insulating layer 2123.

The light-emitting diode LED may include a pixel electrode 210, an emission layer 222 overlapping the pixel electrode 210 through an opening 123OP of a bank layer 123, and an opposite electrode 230 and may further include a first functional layer 221 and a second functional layer 223 under and/or over the emission layer 222. The particular structures and materials of the bank layer 123, a spacer 125 on the bank layer 123, the light-emitting diode LED, and an encapsulation layer 300 may be the same as those described above with reference to FIG. 4.

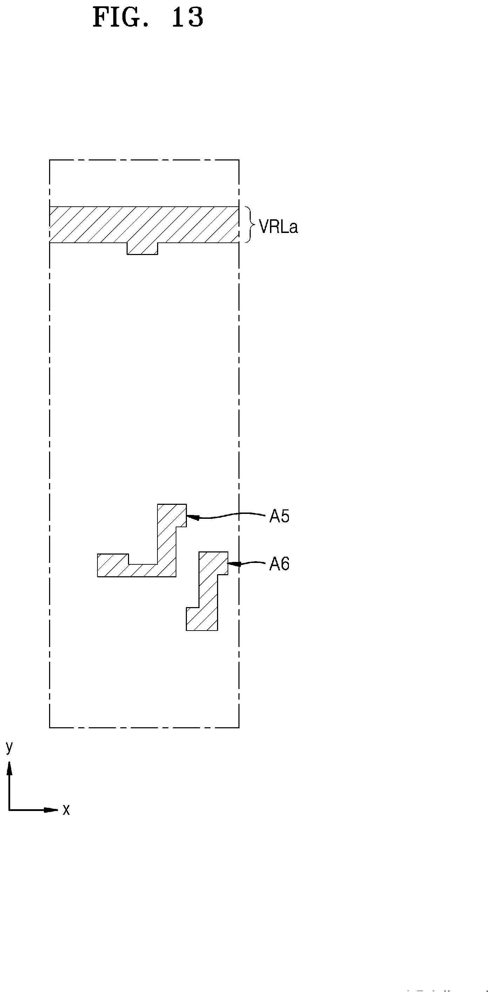

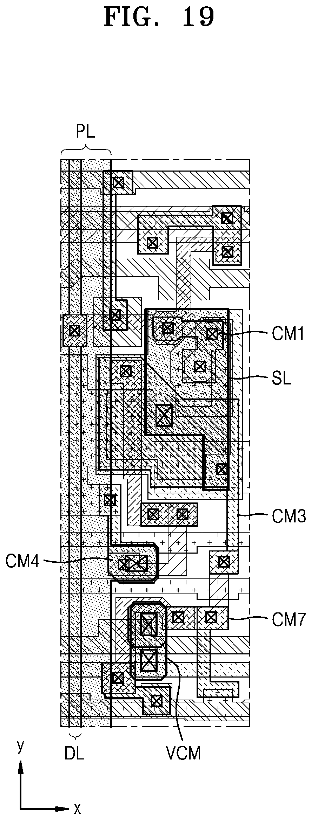

FIGS. 13 to 19 are plan views illustrating a process of forming a pixel circuit included in a display apparatus according to an embodiment. FIG. 19 may correspond to a planar structure of the pixel circuit of the display apparatus described above with reference to FIG. 12.

Referring to FIGS. 12 and 13, a fifth semiconductor layer A5 and a sixth semiconductor layer A6 may be formed over the substrate 100 (see FIG. 12). In some embodiments, an auxiliary reference voltage line VRLa may be formed together with the fifth semiconductor layer A5 and the sixth semiconductor layer A6. A first insulating layer 2110 may be formed over the substrate 100 (see FIG. 12) before the fifth semiconductor layer A5, the sixth semiconductor layer A6, and the auxiliary reference voltage line VRLa be formed.

The fifth semiconductor layer A5, the sixth semiconductor layer A6, and the auxiliary reference voltage line VRLa may include silicon, for example, polysilicon or amorphous silicon.

A second insulating layer 2111 (see FIG. 12) may be formed over the structure illustrated in FIG. 13, for example, over the fifth semiconductor layer A5, the sixth semiconductor layer A6, and the auxiliary reference voltage line VRLa.

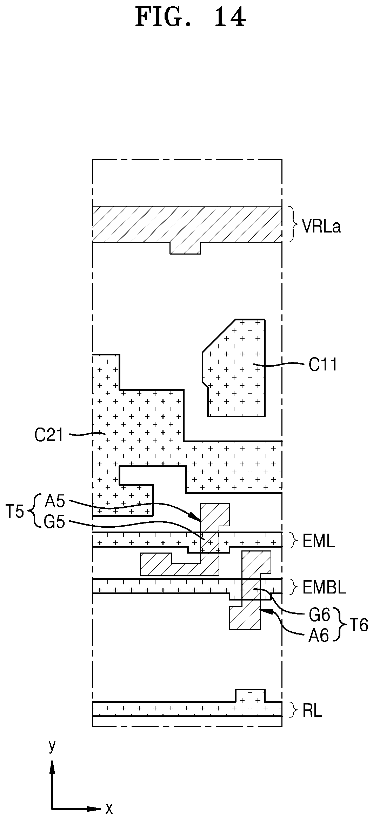

Referring to FIGS. 12 and 14, first electrodes C11 and C21 of the first and second capacitors C1 and C2 (see FIG. 12), a third gate line EML, a fifth gate line EMBL, and a repair line RL may be formed over the second insulating layer 2111 (see FIG. 12).

The first electrode C11 of the first capacitor C1 (see FIG. 12) may have an isolated shape. The first electrode C21 of the second capacitor C2 (FIG. 12) may be spaced apart from the first electrode C11 of the first capacitor C1. The first electrode C21 of the second capacitor C2 (FIG. 12) and a first electrode C21 of a second capacitor C2 of another pixel circuit adjacent thereto in the first direction (e.g., x direction) may be integral with each other.

Each of the third gate line EML, the fifth gate line EMBL, and the repair line RL may extend in the first direction (e.g., x direction). The third gate line EML may include the fifth gate electrode G5 of the fifth transistor T5 overlapping the channel area of the fifth semiconductor layer A5. The fifth gate line EMBL may include the sixth gate electrode G6 of the sixth transistor T6 overlapping the channel area of the sixth semiconductor layer A6.

The first electrodes C11 and C21 of the first and second capacitors C1 and C2 (see FIG. 12), the third gate line EML, the fifth gate line EMBL, and the repair line RL may include a same material. The first electrodes C11 and C21 of the first and second capacitors C1 and C2 (see FIG. 12), the third gate line EML, the fifth gate line EMBL, and the repair line RL may include molybdenum (Mo), aluminium (Al), copper (Cu), titanium (Ti), or a combination thereof and may include a single-layer or multiple-layer structure including the aforementioned material.

After forming the third gate line EML and the fifth semiconductor layer A5, by using the third gate line EML and the fifth gate line EMBL as a self-align mask, a portion of the fifth semiconductor layer A5 and a portion of the sixth semiconductor layer A6 not overlapping the third gate line EML and the fifth gate line EMBL may be doped with a dopant. Portions of the fifth and sixth semiconductor layers A5 and A6 doped with a dopant may correspond to a source area and a drain area. In the doping process, the auxiliary reference voltage line VRLa may also be doped with a dopant.

A third insulating layer 2113 (see FIG. 12) may be formed over the structure described with reference to FIG. 14, for example, over the first electrodes C11 and C21 of the first and second capacitors C1 and C2 (see FIG. 12), the third gate line EML, the fifth gate line EMBL, and the repair line RL.

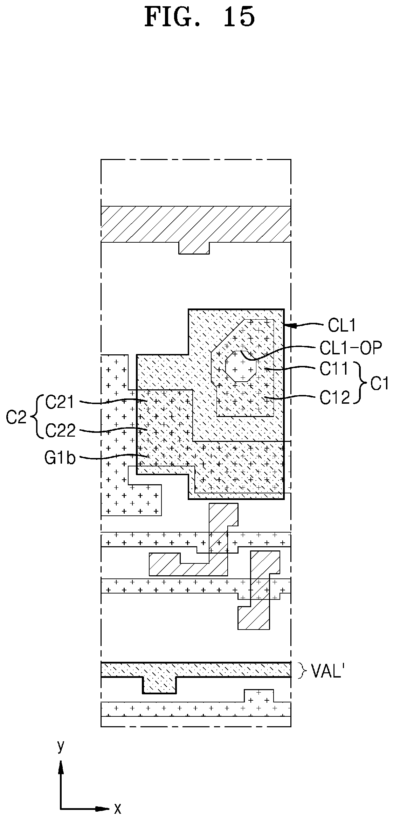

Referring to FIGS. 12 and 15, a first conductive layer CL1 and a first initialization voltage line VAL' may be formed over the third insulating layer 2113 (see FIG. 12). The first conductive layer CL1 may have an isolated shape, and the first initialization voltage line VAL' may extend in the first direction (e.g., x direction).

The first conductive layer CL1 may overlap the first electrodes C11 and C21 of the first and second capacitors C1 and C2, respectively. The first conductive layer CL1 may include second electrodes C12 and C22 of the first and second capacitors C1 and C2, respectively. For example, a portion of the first conductive layer CL1 may be the second electrode C12 of the first capacitor C1 overlapping the first electrode C11 of the first capacitor C1, and another portion thereof may be the second electrode C22 of the second capacitor C2 overlapping the first electrode C21 of the second capacitor C2.

The first conductive layer CL1 may include the 1st-2 gate electrode G1b of the first transistor T1 (see FIG. 4) overlapping the channel area of the first transistor T1 (see FIG. 4). For example, a portion of the first conductive layer CL1 corresponding to the second electrode C22 of the second capacitor C2 may correspond to the 1st-2 gate electrode G1b of the first transistor T1 (see FIG. 4).

The first conductive layer CL1 and the first initialization voltage line VAL may include a same material. The first conductive layer CL1 and the first initialization voltage line VAL may include molybdenum (Mo), aluminium (Al), copper (Cu), titanium (Ti), or a combination thereof and may include a single-layer or multiple-layer structure including the aforementioned material.

A fourth insulating layer 2115 (see FIG. 12) may be formed over the structure illustrated in FIG. 15, for example, over the first conductive layer CL1 and the first initialization voltage line VAL.

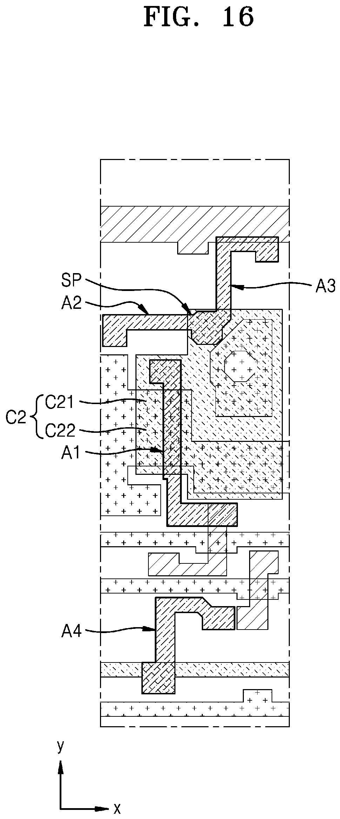

Referring to FIGS. 12 and 16, a first semiconductor layer A1, a second semiconductor layer A2, a third semiconductor layer A3, and a fourth semiconductor layer A4 may be formed over the fourth insulating layer 2115 (see FIG. 12).

The first to fourth semiconductor layers A1, A2, A3, and A4 may include a same material. The first to fourth semiconductor layers A1, A2, A3, and A4 may include an oxide of at least one of indium (In), gallium (Ga), tin (Sn), zirconium (Zr), vanadium (V), hafnium (Hf), cadmium (Cd), germanium (Ge), chromium (Cr), titanium (Ti), aluminium (Al), cesium (Cs), cerium (Ce), and zinc (Zn).

The second semiconductor layer A2 and the third semiconductor layer A3 may be integral with each other and may be separated and spaced apart from the first semiconductor layer A1 and the fourth semiconductor layer A4. The first semiconductor layer A1 may be arranged to overlap the first and second electrodes C21 and C22 of the second capacitor C2.

The integrally connected semiconductor layer corresponding to the second semiconductor layer A2 and the third semiconductor layer A3 may be bent. For example, a semiconductor pattern SP may be bent, and a side centered on the bent portion may correspond to the second semiconductor layer A2 and another side may correspond to the third semiconductor layer A3.

A fifth insulating layer 2117 (see FIG. 12) may be formed over the structure described with reference to FIG. 16, for example, over the first to fourth semiconductor layers A1, A2, A3, and A4.

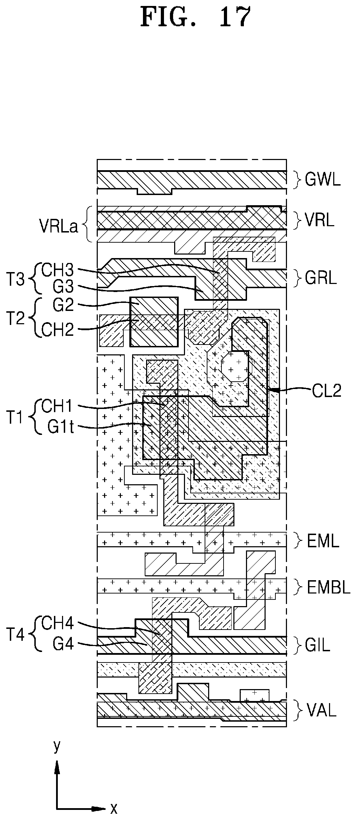

Referring to FIGS. 12 and 17, a second conductive layer CL2, a second gate electrode G2, a first gate line GWL, a reference voltage line VRL, a second gate line GRL, a fourth gate line GIL, and a first initialization voltage line VAL may be formed over the fifth insulating layer 2117 (see FIG. 12).

The second conductive layer CL2, the second gate electrode G2, the first gate line GWL, the reference voltage line VRL, the second gate line GRL, the fourth gate line GIL, and the first initialization voltage line VAL may include a same material. For example, the second conductive layer CL2, the second gate electrode G2, the first gate line GWL, the reference voltage line VRL, the second gate line GRL, the fourth gate line GIL, and the first initialization voltage line VAL may include molybdenum (Mo), aluminium (Al), copper (Cu), titanium (Ti), or a combination thereof and may include a single-layer or multiple-layer structure including the aforementioned material.

Each of the second conductive layer CL2 and the second gate electrode G2 may have an isolated shape. The first gate line GWL, the reference voltage line VRL, the second gate line GRL, the fourth gate line GIL, and the first initialization voltage line VAL may extend in the first direction (e.g., x direction).

The second conductive layer CL2 may overlap the channel area CH1 of the first transistor T1. The second conductive layer CL2 may include the first gate electrode of the first transistor T1, for example, the 1st-1 gate electrode G1t.

The second gate electrode G2 may be arranged adjacent to the second conductive layer CL2. The second gate electrode G2 may overlap the channel area CH2 of the second transistor T2. The second semiconductor layer A2 (see FIG. 16) described with reference to FIG. 16 may include a channel area CH2 of the second transistor T2, a source area arranged on a side of the channel area CH2, and a drain area arranged on another side of the channel area CH2.

Each of the first gate line GWL, the reference voltage line VRL, and the second gate line GRL may be located on a side of the second conductive layer CL2, for example, on the upper side of the second conductive layer CL2, in the plan view of FIG. 17. The second gate line GRL may be located between the first gate line GWL and the second conductive layer CL2, and the reference voltage line VRL may be located between the first gate line GWL and the second gate line GRL. The reference voltage line VRL may overlap the auxiliary reference voltage line VRLa thereunder.

The second gate line GRL may include a third gate electrode G3 overlapping the channel area CH3 of the third transistor T3. The third semiconductor layer A3 (see FIG. 16) described with reference to FIG. 16 may include a channel area CH3 of the third transistor T3, a source area arranged on a side of the channel area CH3, and a drain area arranged on another side of the channel area CH3.

The fourth gate line GIL and the first initialization voltage line VAL may be arranged on another side of the second conductive layer CL2, for example, on the lower side of the second conductive layer CL2, in the plan view of FIG. 17.

The fourth gate line GIL may include a fourth gate electrode G4 overlapping the channel area CH4 of the fourth transistor T4. The fourth semiconductor layer A4 (see FIG. 16) described with reference to FIG. 16 may include a channel area CH4 overlapping the fourth gate electrode G4, a source area arranged on a side of the channel area CH4, and a drain area arranged on another side of the channel area CH4.

The first initialization voltage line VAL may be arranged relatively far away from the second conductive layer CL2. In some embodiments, the third gate line EML, the fourth gate line GIL, and the fifth gate line EMBL may be arranged between the first initialization voltage line VAL and the second conductive layer CL2.

A sixth insulating layer 2119 (see FIG. 12) may be formed over the structure described with reference to FIG. 17.

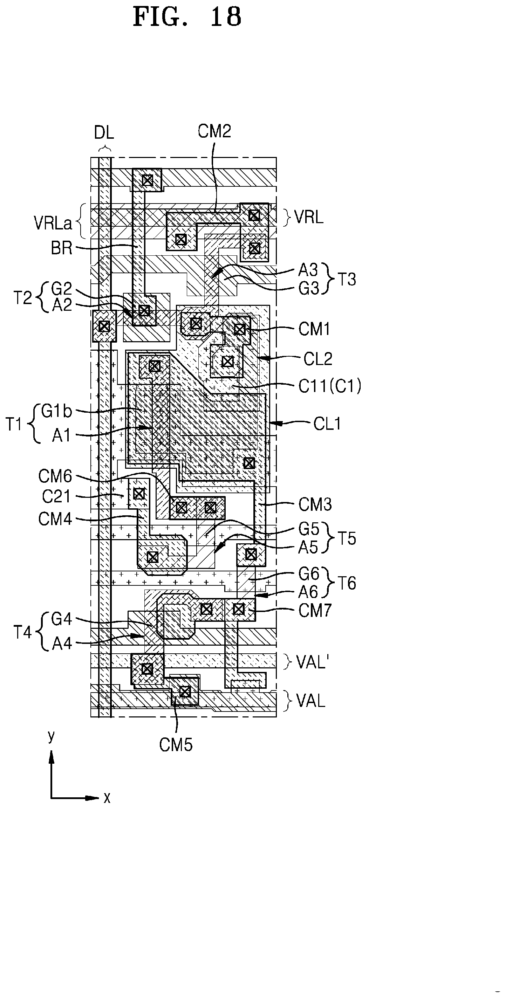

Referring to FIGS. 12 and 18, a data line DL, a bridge electrode BR, and first to seventh connection electrodes CM1, CM2, CM3, CM4, CM5, CM6, and CM7 may be formed over the sixth insulating layer 2119 (see FIG. 12).

The data line DL, the bridge electrode BR, and the first to seventh connection electrodes CM1, CM2, CM3, CM4, CM5, CM6, and CM7 may include a same material. The data line DL, the bridge electrode BR, and the first to seventh connection electrodes CM1, CM2, CM3, CM4, CM5, CM6, and CM7 may include molybdenum (Mo), aluminium (Al), copper (Cu), titanium (Ti), or a combination thereof and may include a single-layer or multiple-layer structure including the aforementioned material.

The data line DL may extend in the second direction (e.g., y direction) intersecting the first direction (e.g., x direction). The data line DL may be electrically connected to a portion of the second semiconductor layer A2, for example, a drain area thereof, through a contact hole 41a passing through an insulating layer arranged between the data line DL and the second semiconductor layer A2 of the second transistor T2.

The bridge electrode BR may electrically connect the first gate line GWL and the second gate electrode G2 to each other. A portion of the bridge electrode BR may be electrically connected to the first gate line GWL through a contact hole 72a passing through at least one insulating layer arranged between the first gate line GWL and the bridge electrode BR. Another portion of the bridge electrode BR may be electrically connected to the second gate electrode G2 through a contact hole 73a passing through at least one insulating layer arranged between the second gate electrode G2 and the bridge electrode BR.

The first connection electrode CM1 may electrically connect the second semiconductor layer A2 of the second transistor T2, the third semiconductor layer A3 of the third transistor T3, the 1st-1 gate electrode G1t of the first transistor T1, and the first electrode C11 of the first capacitor C1 to each other. For example, the first connection electrode CM1 may be electrically connected to the drain area of the third transistor T3 and the source area of the second transistor T2 through a contact hole passing through at least one insulating layer arranged between the first connection electrode CM1 and the drain area of the third semiconductor layer A3 of the third transistor T3 and between the first connection electrode CM1 and the source area of the second semiconductor layer A2 of the second transistor T2. The first connection electrode CM1 may be electrically connected to the second conductive layer CL2 through a contact hole passing through at least one insulating layer arranged between the first connection electrode CM1 and the second conductive layer CL2. The first connection electrode CM1 may be electrically connected to the first electrode C11 of the first capacitor C1 through an opening CL1-OP (see FIG. 15) of the first conductive layer CL1 (see FIG. 15) and a contact hole passing through at least one insulating layer arranged between the first electrode C11 of the first capacitor C1 and the first connection electrode CM1.

The second connection electrode CM2 may electrically connect the third semiconductor layer A3 of the third transistor T3 and the reference voltage line VRL to each other. The second connection electrode CM2 may be electrically connected to the source area of the third semiconductor layer A3 through a contact hole passing through at least one insulating layer arranged between the second connection electrode CM2 and the source area of the third semiconductor layer A3. The second connection electrode CM2 may be electrically connected to the reference voltage line VRL through a contact hole passing through at least one insulating layer arranged between the second connection electrode CM2 and the reference voltage line VRL. In some embodiments, the second connection electrode CM2 may be electrically connected to the auxiliary reference voltage line VRLa through a contact hole between the second connection electrode CM2 and the auxiliary reference voltage line VRLa.

The third connection electrode CM3 may overlap the second conductive layer CL2 and may be electrically connected to the source area of the first semiconductor layer A1 through a contact hole passing through at least one insulating layer arranged between the third connection electrode CM3 and the first semiconductor layer A1. The third connection electrode CM3 may be electrically connected to the first conductive layer CL1 through a contact hole passing through at least one insulating layer arranged between the first conductive layer CL1 and the third connection electrode CM3. The third connection electrode CM3 may be electrically connected to the drain area of the sixth semiconductor layer A6 through a contact hole passing through at least one insulating layer arranged between the sixth semiconductor layer A6 of the sixth transistor T6 and the third connection electrode CM3.

The fourth connection electrode CM4 may electrically connect the fifth semiconductor layer A5 of the fifth transistor T5 and the first electrode C21 of the second capacitor to each other. The fourth connection electrode CM4 may be electrically connected to the fifth semiconductor layer A5 through a contact hole passing through at least one insulating layer arranged between the fifth semiconductor layer A5 and the fourth connection electrode CM4. The fourth connection electrode CM4 may be electrically connected to the first electrode C21 of the second capacitor through a contact hole passing through at least one insulating layer arranged between the first electrode C21 of the second capacitor and the fourth connection electrode CM4.

The fifth connection electrode CM5 may electrically connect the fourth semiconductor layer A4 of the fourth transistor T4 and the first initialization voltage line VAL to each other. The fifth connection electrode CM5 may be electrically connected to the source area of the fourth semiconductor layer A4 through a contact hole passing through at least one insulating layer arranged between the source area of the fourth semiconductor layer A4 and the fifth connection electrode CM5. The fifth connection electrode CM5 may be electrically connected to the first initialization voltage line VAL through a contact hole passing through at least one insulating layer arranged between the first initialization voltage line VAL and the fifth connection electrode CM5.

One of the two first initialization voltage lines VAL and VAL' arranged adjacent to each other may be electrically connected to the pixel circuit electrically connected to the light-emitting diode emitting light of a first color. Also, the other one of the two first initialization voltage lines VAL and VAL' may be electrically connected to the pixel circuits electrically connected to the light-emitting diodes emitting light of colors (e.g., a second color and a third color) different from the first color. In this regard, the pixel circuit of FIG. 18 is illustrated as including the fourth transistor T4 electrically connected to the first initialization voltage line VAL. Although not illustrated in FIG. 18, a fourth transistor of an adjacent pixel circuit may be electrically connected to another first initialization voltage line VAL'.

The sixth connection electrode CM6 may electrically connect the fifth semiconductor layer A5 of the fifth transistor T5 and the first semiconductor layer A1 to each other. A portion of the sixth connection electrode CM6 may be electrically connected to the drain area of the fifth semiconductor layer A5 through a contact hole passing through at least one insulating layer arranged between the sixth connection electrode CM6 and the drain area of the fifth semiconductor layer A5. The sixth connection electrode CM6 may be electrically connected to the drain area of the first semiconductor layer A1 through a contact hole passing through at least one insulating layer arranged between the sixth connection electrode CM6 and the first semiconductor layer A1.

The seventh connection electrode CM7 may electrically connect the fourth semiconductor layer A4 of the fourth transistor T4 and the sixth semiconductor layer A6 of the sixth transistor T6 to each other. The seventh connection electrode CM7 may be electrically connected to the drain area of the fourth semiconductor layer A4 and the source area of the sixth semiconductor layer A6 through a contact hole passing through at least one insulating layer arranged between the fourth semiconductor layer A4 and the seventh connection electrode CM7 and between the sixth semiconductor layer A6 and the seventh connection electrode CM7.

A seventh insulating layer 2121 (see FIG. 12) may be formed over the structure described with reference to FIG. 18.

Referring to FIGS. 12 and 19, a driving voltage line PL, a cover layer SL, and a via connection electrode VCM may be formed over the seventh insulating layer 2121 (see FIG. 12).

The driving voltage line PL, the cover layer SL, and the via connection electrode VCM may include a same material. The driving voltage line PL, the cover layer SL, and the via connection electrode VCM may include molybdenum (Mo), aluminium (Al), copper (Cu), titanium (Ti), or a combination thereof and may include a single-layer or multiple-layer structure including the aforementioned material.

The driving voltage line PL may extend in the second direction (e.g., y direction). In some embodiments, the driving voltage line PL may overlap the data line DL. The driving voltage line PL may be electrically connected to the fourth connection electrode CM4 through a contact hole passing through at least one insulating layer arranged between the fourth connection electrode CM4 and the driving voltage line PL.

The cover layer SL may have an isolated shape and may be electrically connected to the third connection electrode CM3 through a contact hole. The cover layer SL may overlap the first connection electrode CM1, may shield the first connection electrode CM1, and may prevent the first connection electrode CM1 from forming a parasitic capacitance with another component therearound, to provide a high-quality image.

The via connection electrode VCM may be electrically connected to the seventh connection electrode CM7. The via connection electrode VCM may be electrically connected to the seventh connection electrode CM7 through a contact hole. An eighth insulating layer 2123 (see FIG. 12) may be formed over the structure illustrated in FIG. 19. Also, as described with reference to FIG. 12, the pixel electrode 210 (see FIG. 12) of the light-emitting diode LED may be electrically connected to the via connection electrode VCM through a contact hole passing through the eighth insulating layer 2123 (see FIG. 12).

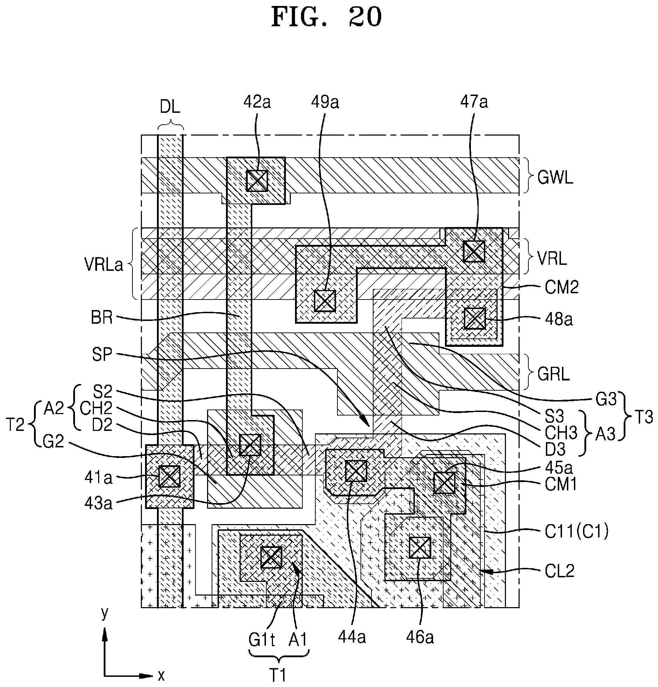

FIG. 20 is a plan view illustrating a portion of a pixel circuit according to an embodiment. FIG. 20 may correspond to, for example, a plan view illustrating a portion of the pixel circuit described with reference to FIGS. 13 to 19.

Referring to FIG. 20, the first gate line GWL and the second gate line GRL may extend in the first direction (e.g., x direction). The reference voltage line VRL may be arranged between the first gate line GWL and the second gate line GRL. The reference voltage line VRL may extend in the first direction (e.g., x direction). The data line DL may extend in the second direction (e.g., y direction) intersecting the first direction (e.g., x direction).

The semiconductor pattern SP may be arranged apart from the first gate line GWL and the first semiconductor layer A1. The semiconductor pattern SP may include the second semiconductor layer A2 and the third semiconductor layer A3. In other words, the second semiconductor layer A2 and the third semiconductor layer A3 may be arranged along the semiconductor pattern SP as a portion of the semiconductor pattern SP that may be a single body.

The semiconductor pattern SP may have a bent shape. For example, the semiconductor pattern SP may include the second semiconductor layer A2 extending in the first direction (e.g., x direction) and the third semiconductor layer A3 extending in the second direction (e.g., y direction) around the bent point.

The second semiconductor layer A2 may be spaced apart from the first gate line GWL by a certain distance without overlapping the first gate line GWL. The second gate line GRL and the reference voltage line VRL may be located in the space between the first gate line GWL and the second semiconductor layer A2.

The channel area CH2 of the second semiconductor layer A2 may overlap the second gate electrode G2. The second gate electrode G2 may have an isolated shape and may be spaced apart from the first gate line GWL by a certain distance without overlapping the first gate line GWL. The second gate electrode G2 may be electrically connected to the first gate line GWL by the bridge electrode BR extending in the second direction (e.g., y direction). The bridge electrode BR may electrically connect the first gate line GWL and the second gate electrode G2 to each other through contact holes 42a and 43a.

One of the source area S2 and the drain area D2 located on both sides of the channel area CH2 of the second semiconductor layer A2 may be electrically connected to the data line DL. For example, the drain area D2 of the second semiconductor layer A2 may be electrically connected to the data line DL through a contact hole 41a. The other one of the source area S2 and the drain area D2 of the second transistor T2 and the third semiconductor layer A3 may be integral with each other. For example, the source area S2 of the second semiconductor layer A2 may be electrically connected to the drain area D3 of the third semiconductor layer A3. The source area S2 and the drain area D2 of the second semiconductor layer A2 may be arranged in the first direction (e.g., x direction) with the channel area CH2 therebetween.

The third semiconductor layer A3 may overlap the second gate line GRL. The third semiconductor layer A3 may include a channel area CH3 overlapping the second gate line GRL and a source area S3 and a drain area D3 arranged on both sides of the channel area CH3 in the second direction (e.g., y direction). A portion of the second gate line GRL may correspond to the third gate electrode G3.

The drain area D3 of the third semiconductor layer A3 may be electrically connected to the source area S2 of the second semiconductor layer A2. The second and third semiconductor layers A2 and A3 that are integral with each other may be electrically connected through the first connection electrode CM1 to the 1st-1 gate electrode G1t of the first transistor T1, for example, to the second conductive layer CL2.

The first connection electrode CM1 may be electrically connected through a contact hole 44a to the connection portion between the second semiconductor layer A2 and the third semiconductor layer A3 (or the bent portion of the semiconductor pattern SP including the second semiconductor layer A2 and the third semiconductor layer A3). In other words, the first connection electrode CM1 may be electrically connected to the drain area D3 of the third semiconductor layer A3 and the source area S2 of the second semiconductor layer A2 through a contact hole 44a. The first connection electrode CM1 may be electrically connected through a contact hole 45a to the second conductive layer CL2 including the 1st-1 gate electrode G1t of the first transistor T1. The first connection electrode CM1 may be electrically connected to the first electrode C11 of the first capacitor C1 through a contact hole 46a. The 1st-1 gate electrode G1t may be disposed over the first semiconductor layer A1, and the first connection electrode CM1 may be arranged apart from the first gate line GWL.

One of the source area S3 and the drain area D3 of the third semiconductor layer A3 may be electrically connected to the reference voltage line VRL. For example, the reference voltage line VRL and the source area S3 of the third semiconductor layer A3 may be electrically connected through the second connection electrode CM2. The second connection electrode CM2 may be electrically connected to the source area S3 of the third semiconductor layer A3 and the reference voltage line VRL through contact holes 47a and 48a, respectively. In some embodiments, the second connection electrode CM2 may be electrically connected to the auxiliary reference voltage line VRLa through a contact hole 49a.

Through the structure illustrated in FIG. 20, the component(s) electrically connected to the 1st-1 gate electrode G1t of the first transistor T1 may not overlap the first gate line GWL, and thus, an undesired parasitic capacitance may be prevented from occurring between the aforementioned component(s) and the first gate line GWL. For example, because the first connection electrode CM1 does not overlap the first gate line GWL, a parasitic capacitance may be prevented from occurring between the first node N1 and the first gate line GWL described with reference to FIG. 3B, for example, between the first connection electrode CM1 and the first gate line GWL, and the occurrence of local spots in the display area may be prevented or minimized.

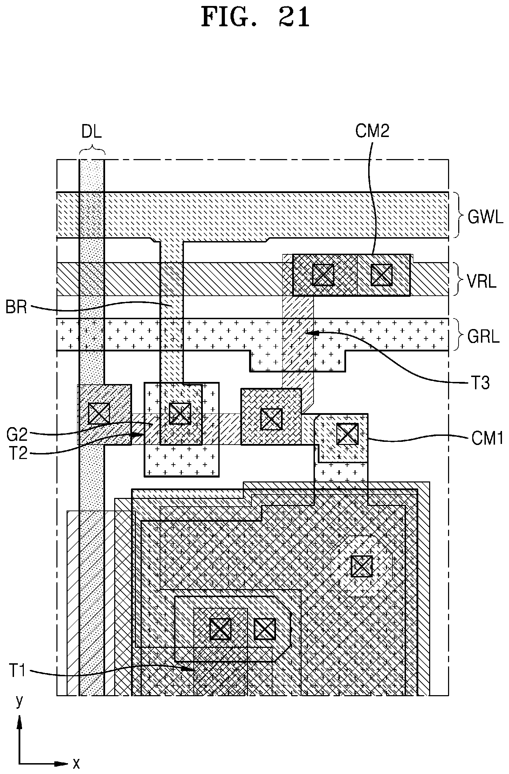

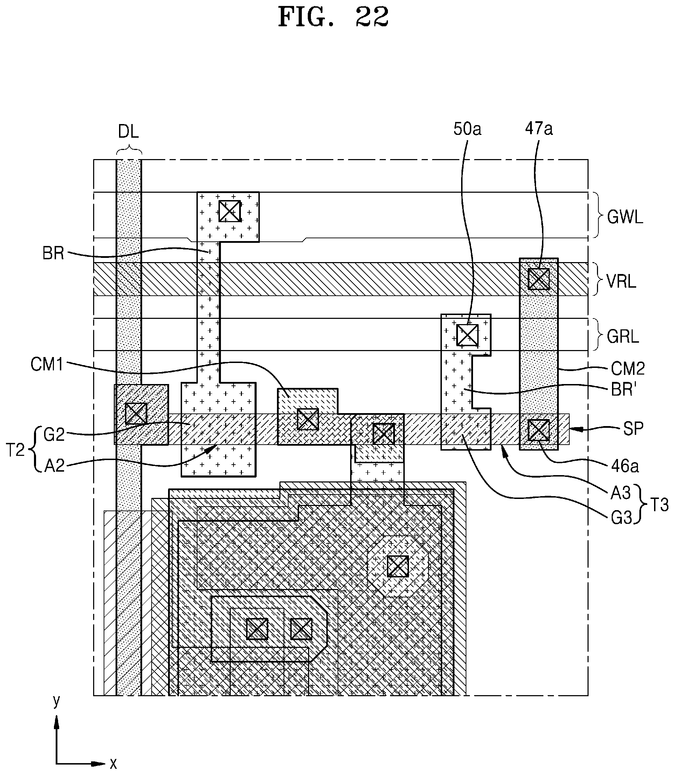

FIGS. 21 and 22 are each a plan view illustrating a portion of a pixel circuit of a display apparatus according to an embodiment.

According to the embodiments described above with reference to FIGS. 11 and 20, the bridge electrode BR and the first connection electrode CM1 may be arranged on a same layer and may be arranged on a different layer than the first gate line GWL; however, the disclosure may not be limited thereto.

In an embodiment, as illustrated in FIG. 21, the bridge electrode BR and the first gate line GWL may include a same material and may be arranged on a same layer. For example, the first gate line GWL and the bridge electrode BR may be arranged on a same layer (e.g., the fourth insulating layer 114 of FIG. 4 or the sixth insulating layer 2119 of FIG. 12) and they may be integral with each other. The data line DL and the driving voltage line PL (see FIGS. 4 and 12) may be arranged on a same layer and may not overlap each other.

According to the embodiments described above with reference to FIGS. 11 and 20, the bridge electrode BR and the first connection electrode CM1 may be arranged on a same layer; however the disclosure may not be limited thereto.

As illustrated in FIG. 22, the bridge electrode BR may be arranged on a different layer than the first connection electrode CM1. The bridge electrode BR and the second gate electrode G2 may be integral with each other. The first gate line GWL may be disposed over the bridge electrode BR, and the first gate line GWL may be electrically connected to the bridge electrode BR through a contact hole. A portion of the bridge electrode BR may overlap a portion of the second semiconductor layer A2, and a portion of the bridge electrode BR overlapping a portion of the second semiconductor layer A2 may correspond to the second gate electrode G2.

Referring to FIG. 22, the semiconductor pattern SP may extend in the first direction (e.g., x direction) without being bent and may include the second semiconductor layer A2 and the third semiconductor layer A3. In other words, the second semiconductor layer A2 and the third semiconductor layer A3 may extend in a same direction and may be integral with each other.

The second connection electrode CM2 may extend in the second direction (e.g., y direction) to overlap the second gate line GRL and may be electrically connected to the third semiconductor layer A3 and the reference voltage line VRL through contact holes 46a and 47a, respectively.

The second gate line GRL may be electrically connected to a second bridge electrode BR'. The second bridge electrode BR' may be electrically connected through a contact hole 50a to the second gate line GRL disposed over the second bridge electrode BR' and may extend toward the third semiconductor layer A3 to overlap the channel area CH3 of the third semiconductor layer A3. A portion of the second bridge electrode BR' may overlap a portion of the third semiconductor layer A3, and a portion of the second bridge electrode BR' overlapping a portion of the third semiconductor layer A3 may correspond to the third gate electrode G3.

While the present invention has been described with reference to the embodiments illustrated in the drawings, these are merely illustrative, and it should be understood by those skilled in the art that various modifications and other equivalent embodiments may be made therefrom. Therefore, the technical scope of protection of the present invention should be defined by the technical spirit of the appended claims.

## Claims

1. A display apparatus comprising:
a first gate line and a second gate line extending in a first direction;
a data line extending in a second direction intersecting the first direction;
a first transistor comprising a first semiconductor layer and a first gate electrode overlapping the first semiconductor layer;
a second transistor electrically connected to the first transistor and comprising a second semiconductor layer electrically connected to the data line and a second gate electrode overlapping the second semiconductor layer;
a third transistor electrically connected to the first transistor and the second transistor and comprising a third semiconductor layer overlapping the second gate line; and
a bridge electrode electrically connecting the first gate line to the second gate electrode.

2. The display apparatus of claim 1, further comprising:
a first connection electrode electrically connecting the first gate electrode, the second semiconductor layer, and the third semiconductor layer to each other,
wherein the first connection electrode does not overlap the first gate line.

3. The display apparatus of claim 2, wherein the second gate line is disposed between the first connection electrode and the first gate line.

4. The display apparatus of claim 2, further comprising:
a first capacitor electrically connected to the first gate electrode,
wherein the first connection electrode is electrically connected to a first electrode of the first capacitor.

5. The display apparatus of claim 4, wherein the first electrode of the first capacitor and the first gate electrode are integral with each other.

6. The display apparatus of claim 4, wherein the first electrode of the first capacitor and the first gate electrode are arranged on different layers.

7. The display apparatus of claim 1, wherein the second semiconductor layer and the third semiconductor layer are integral with each other.

8. The display apparatus of claim 1, wherein the first gate line comprises:
a 1st-1 gate line; and
a 1st-2 gate line overlapping the 1st-1 gate line, wherein
at least one insulating layer is disposed between the 1st-1 gate line and the 1st-2 gate line.

9. The display apparatus of claim 1, wherein
the second gate line is arranged between the first gate line and the second semiconductor layer, and
the second gate line overlaps the third semiconductor layer.

10. The display apparatus of claim 1, further comprising:
a reference voltage line electrically connected to the third semiconductor layer,
wherein the reference voltage line extends in the first direction.

11. The display apparatus of claim 10, wherein the reference voltage line is arranged between the first gate line and the second gate line.

12. The display apparatus of claim 1, wherein the bridge electrode and the first gate line are integral with each other.

13. The display apparatus of claim 1, wherein the bridge electrode comprises the second gate electrode.

14. A display apparatus comprising:
a first gate line extending in a first direction;
a data line extending in a second direction intersecting the first direction;
a first semiconductor layer including a first channel area;
a conductive layer comprising a first gate electrode overlapping the first channel area;
a semiconductor pattern spaced apart from the first gate line and the first semiconductor layer and comprising a second channel area and a third channel area;
a second gate electrode overlapping the second channel area;
a bridge electrode electrically connecting the first gate line to the second gate electrode; and
a first connection electrode electrically connecting the first gate electrode to the semiconductor pattern.

15. The display apparatus of claim 14, wherein the first connection electrode is electrically connected to a middle portion of the semiconductor pattern disposed between the second channel area and the third channel area.

16. The display apparatus of claim 15, wherein
the semiconductor pattern includes a bent portion in a plan view, and
the first connection electrode is electrically connected to the bent portion of the semiconductor pattern.

17. The display apparatus of claim 16, further comprising:
a second gate line extending in the first direction,
wherein the second gate line overlaps the third channel area.

18. The display apparatus of claim 17, further comprising:
a reference voltage line, wherein
the data line is electrically connected to a first portion of the semiconductor pattern,
the reference voltage line is electrically connected to a second portion of the semiconductor pattern, and
the second channel area and the third channel area are disposed between
the first portion and the second portion of the semiconductor pattern.

19. The display apparatus of claim 18, wherein the reference voltage line extends in the first direction and is disposed between the first gate line and the second gate line.

20. The display apparatus of claim 14, wherein the first gate line comprises:
a 1st-1 gate line; and
a 1st-2 gate line overlapping the 1st-1 gate line, wherein
at least one insulating layer is disposed between the 1st-1 gate line and
the 1st-2 gate line, and
the 1st-2 gate line is electrically connected to the 1st-1 gate line through a contact hole passing through the at least one insulating layer.

21. The display apparatus of claim 14, further comprising:
a first capacitor comprising a plurality of electrodes.

22. The display apparatus of claim 21, wherein the conductive layer comprises one of the plurality of electrodes of the first capacitor.

23. The display apparatus of claim 21, wherein
each of the plurality of electrodes of the first capacitor are disposed on a different layer than the conductive layer, and
the first connection electrode is electrically connected to one of the plurality of electrodes of the first capacitor.

24. The display apparatus of claim 14, wherein the bridge electrode and the first gate line are integral with each other.

25. The display apparatus of claim 14, wherein the bridge electrode comprises the second gate electrode.
